# FASCICULE DE BREVET EUROPEEN

(11) **EP 3 239 671 B1**
(45) Date de publication et mention de la délivrance du brevet: **14.08.2019**
(21) Numéro de dépôt: 17167674.5
(22) Date de dépôt: 24.04.2017
(51) Int. Cl.: G01J 5/04, G01J 5/02, G01J 5/10, G01J 5/20, G01J 5/08, G02B 5/28, G01J 3/26

(54) **DISPOSITIF DE DETECTION DE RAYONNEMENT ELECTROMAGNETIQUE A STRUCTURE D`ENCAPSULATION COMPORTANT AU MOINS UN FILTRE INTERFERENTIEL**
VORRICHTUNG ZUR ERFASSUNG VON ELEKTROMAGNETISCHER STRAHLUNG MIT EINER EINKAPSELUNGSSTRUKTUR, DIE MINDESTENS EINEN INTERFERENZFILTER UMFASST
DEVICE FOR DETECTING ELECTROMAGNETIC RADIATION WITH ENCAPSULATION STRUCTURE COMPRISING AT LEAST ONE INTERFERENCE FILTER

(30) Priorité: 25.04.2016 FR 1653609
(43) Date de publication de la demande: 01.11.2017
(73) Titulaire: COMMISSARIAT À L'ÉNERGIE ATOMIQUE ET AUX ÉNERGIES ALTERNATIVES, 75015 Paris (FR)
(72) Inventeur: FREY, Laurent, 38600 FONTAINE (FR); BOUTAMI, Salim, 38100 GRENOBLE (FR); YON, Jean-Jacques, 38360 SASSENAGE (FR)
(74) Mandataire: GIE Innovation Competence Group

(56) Documents cités:
- WO-A1-96/21140
- WO-A1-2015/169761
- DE-A1-102011 111 883
- US-A- 5 726 805
- US-A1- 2010 294 935
- US-A1- 2015 316 472
- US-B2- 8 933 389

## Description

### DOMAINE TECHNIQUE

Le domaine de l'invention est celui des dispositifs de détection de rayonnement électromagnétique, en particulier infrarouge ou térahertz, comportant au moins un détecteur thermique encapsulé dans une cavité formée au moins en partie par une structure d'encapsulation au niveau de laquelle se situe au moins un filtre interférentiel. L'invention s'applique en particulier au domaine de la détection multispectrale.

### ÉTAT DE LA TECHNIQUE ANTÉRIEURE

Les dispositifs de détection de rayonnement électromagnétique, par exemple infrarouge ou térahertz, peuvent comprendre une matrice de détecteurs thermiques, dits élémentaires, chaque détecteur comportant une portion absorbante apte à absorber le rayonnement électromagnétique à détecter. Pour assurer l'isolation thermique des détecteurs thermiques, les portions absorbantes se présentent habituellement sous la forme de membranes suspendues au-dessus du substrat par des piliers d'ancrage, et sont isolées thermiquement de celui-ci par des bras de maintien et d'isolation thermique. Ces piliers d'ancrage et bras d'isolation présentent également une fonction électrique en reliant électriquement les membranes suspendues à un circuit de lecture généralement disposé dans le substrat. WO9621140 porte sur un détecteur infrarouge à filtre interférentiel à cavité Fabry-Pérot.

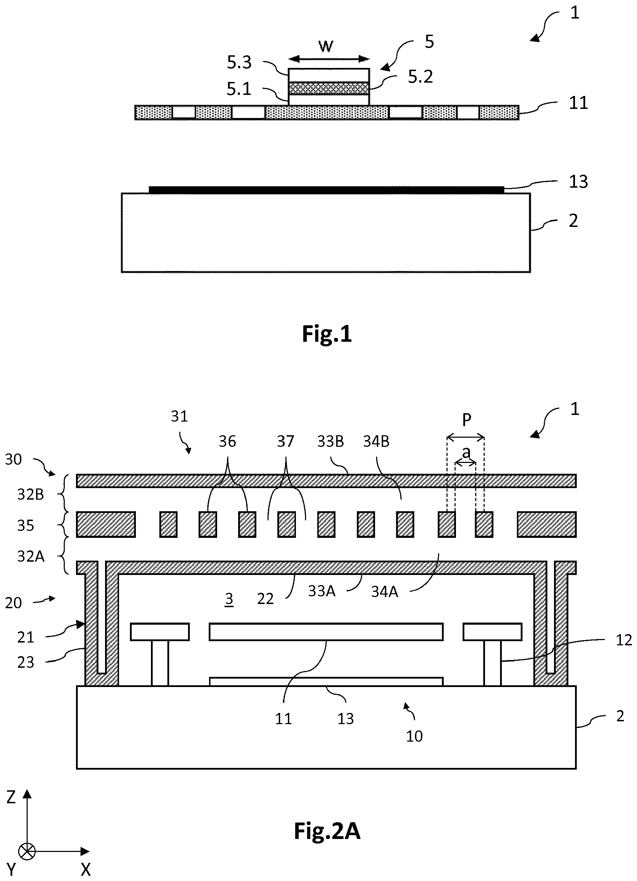

Dans le but d'assurer une détection multispectrale, c'est-à-dire de filtrer les longueurs d'onde dans une gamme de détection du détecteur thermique, le dispositif de détection peut comporter des filtres interférentiels associés chacun à un détecteur thermique. A ce titre, la figure 1 illustre un exemple de dispositif de détection multispectrale tel que décrit dans le document FR2977937. Le dispositif de détection 1 comporte une matrice de micro-bolomètres comportant chacun un filtre 5 de type MIM (Métal-Isolant-Métal) reposant directement sur la membrane absorbante 11. Chaque filtre MIM 5 est formé d'un empilement de deux couches métalliques 5.1, 5.3 séparées l'une de l'autre par une couche isolante 5.2, l'empilement 5 étant structuré sous forme de plots dont les dimensions latérales définissent la valeur de la longueur d'onde de résonance du filtre. Ainsi, le dispositif de détection comporte une pluralité de filtres MIM différents les uns des autres, disposés sur les membranes absorbantes à raison d'un filtre par membrane, de manière à permettre la détection simultanée de plusieurs longueurs d'onde différentes dans un domaine spectral de détection.

Cependant, il existe un besoin de disposer d'un dispositif de détection d'un rayonnement électromagnétique comportant au moins un détecteur thermique et au moins un filtre interférentiel, dont au moins une partie des propriétés du détecteur thermique n'est pas affectée par le filtre interférentiel.

### EXPOSÉ DE L'INVENTION

L'invention a pour objectif de remédier au moins en partie aux inconvénients de l'art antérieur, et plus particulièrement de proposer un dispositif de détection de rayonnement électromagnétique comportant :
- un substrat ;
- au moins un détecteur thermique, disposé sur le substrat ;
- une structure d'encapsulation agencée de manière à définir avec le substrat une cavité logeant ledit détecteur thermique, comportant au moins une couche mince d'encapsulation s'étendant au-dessus du détecteur thermique.

Selon l'invention, il comporte en outre :
- au moins un filtre interférentiel à cavité Fabry-Pérot, disposé au niveau de la structure d'encapsulation et à distance du détecteur thermique, formé par des premier et deuxième miroirs semi-réfléchissants espacés l'un de l'autre par une couche dite structurée ;
- chaque miroir semi-réfléchissant comportant une couche dite de haut indice de réfraction réalisée en au moins un matériau diélectrique ou semiconducteur, laquelle présentant une épaisseur égale à un multiple du rapport d'une longueur d'onde de référence comprise dans un domaine spectral de détection du détecteur thermique sur quatre fois son indice de réfraction ;
- la couche structurée comportant une alternance, dans un plan parallèle au plan du substrat, de portions dites de haut indice de réfraction réalisées en au moins un matériau diélectrique ou semiconducteur, et de portions dites de bas indice de réfraction réalisées en un milieu dont l'indice de réfraction est inférieur à celui du matériau des portions de haut indice ;
- la couche de haut indice de l'un desdits miroirs semi-réfléchissants étant au moins en partie formée de ladite couche mince d'encapsulation.

Certains aspects préférés mais non limitatifs de ce dispositif de détection de rayonnement électromagnétique sont les suivants.

Chaque miroir semi-réfléchissant peut comporter une unique couche de haut indice, et au moins l'un desdits miroirs semi-réfléchissants peut comporter une couche dite de bas indice réalisée en un milieu dont l'indice de réfraction est inférieur à celui du matériau de la couche de haut indice, ladite couche de bas indice étant située entre la couche de haut indice et la couche structurée.

La différence entre l'indice de réfraction du matériau de la couche de haut indice et celui du milieu de la couche de bas indice peut être supérieure ou égale à 1,5.

Le milieu de la couche de bas indice et des portions de bas indice peut être du vide ou un gaz.

La couche de haut indice d'au moins l'un desdits miroirs semi-réfléchissants peut être formée d'un empilement d'au moins deux sous-couches en contact l'une de l'autre et réalisées en des matériaux différents.

La couche structurée peut présenter une proportion volumique de portions de haut indice supérieure ou égale à 30%.

La couche structurée peut comporter une couche continue sur laquelle reposent les portions de haut indice.

La couche de haut indice d'un miroir semi-réfléchissant dit supérieur peut comporter une paroi dite supérieure située en regard de la couche structurée, et des parois dites latérales situées de part et d'autre de la paroi supérieure, la couche structurée étant maintenue au-dessus de la couche de haut indice d'un miroir semi-réfléchissant dit inférieur par les parois latérales.

La couche mince d'encapsulation peut s'étendre continûment autour du détecteur thermique de manière à former une paroi supérieure située au-dessus du détecteur thermique et une paroi latérale reposant sur le substrat.

Le dispositif de détection peut comporter :
- une pluralité de détecteurs thermiques disposés sur le substrat, au-dessus desquels s'étend ladite couche mince d'encapsulation ;
- une pluralité de filtres interférentiels à cavité Fabry-Pérot, disposés chacun au niveau de la structure d'encapsulation ;
- la couche mince d'encapsulation étant commune à plusieurs couches de haut indice de l'un desdits miroirs semi-réfléchissants des différents filtres interférentiels.

Les miroirs semi-réfléchissants et les couches structurées des filtres interférentiels peuvent être respectivement coplanaires d'un filtre interférentiel à l'autre.

L'invention porte également sur un procédé de réalisation d'un dispositif de détection selon l'une quelconque des caractéristiques précédentes, comportant au moins les étapes suivantes :
a. réalisation d'au moins un détecteur thermique ;
b. réalisation d'une structure d'encapsulation agencée de manière à définir avec le substrat une cavité logeant ledit détecteur thermique, comportant au moins une couche mince d'encapsulation s'étendant au-dessus du détecteur thermique et reposant sur une couche sacrificielle recouvrant ledit détecteur thermique ;
c. réalisation d'au moins un filtre interférentiel à cavité Fabry-Pérot, une couche sacrificielle étant située entre les portions de haut indice de la couche structurée, et éventuellement entre une couche de haut indice et la couche structurée ;
d. élimination desdites couches sacrificielles.

L'élimination des couches sacrificielles peut être effectuée en une même étape, ultérieurement à l'étape de réalisation du filtre interférentiel, les couches sacrificielles étant réalisées en un même matériau, les couches de haut indice des deux miroirs semi-réfléchissants comportant chacune un orifice traversant, et les portions de bas indice de la couche structurée étant traversants.

L'élimination des couches sacrificielles peut être réalisée en deux sous-étapes :
- une première sous-étape d'élimination de la couche sacrificielle sur laquelle repose la couche mince d'encapsulation, effectuée antérieurement à l'étape de réalisation du filtre interférentiel, la couche mince d'encapsulation comportant un orifice traversant et une couche de scellement étant ensuite déposée sur la couche mince d'encapsulation de manière à obturer l'orifice traversant ; et
- une deuxième sous-étape d'élimination de la couche sacrificielle située entre les portions de haut indice de la couche structurée, la couche de haut indice du miroir semi-réfléchissant supérieur comportant un orifice traversant.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
- la figure 1, déjà décrite, est une vue schématique d'un dispositif de détection multispectrale selon un exemple de l'art antérieur ;
- la figure 2A est une vue schématique en coupe d'un dispositif de détection de rayonnement électromagnétique selon un premier mode de réalisation; la figure 2B est une vue de dessus d'un exemple de motif élémentaire de la couche structurée ; et la figure 2C illustre la réponse spectrale d'un tel dispositif de détection pour différentes valeurs du facteur de remplissage de la couche structurée ;
- la figure 3A est une vue schématique d'une première variante de filtre interférentiel, et la figure 3B illustre la réponse spectrale d'un tel dispositif de détection pour différentes valeurs du facteur de remplissage de la couche structurée ;
- la figure 4A est une vue schématique d'une deuxième variante de filtre interférentiel, et la figure 4B illustre la réponse spectrale d'un tel dispositif de détection pour différentes valeurs du facteur de remplissage de la couche structurée ;
- la figure 5A est une vue schématique d'une troisième variante de filtre interférentiel, et la figure 5B illustre la réponse spectrale d'un tel dispositif de détection pour différentes valeurs du facteur de remplissage de la couche structurée ;
- la figure 6A est une vue schématique d'une quatrième variante de filtre interférentiel, et la figure 6B illustre la réponse spectrale d'un tel dispositif de détection pour différentes valeurs du facteur de remplissage de la couche structurée ;
- la figure 7A est une vue schématique d'une cinquième variante de filtre interférentiel, et la figure 7B illustre la réponse spectrale d'un tel dispositif de détection pour différentes valeurs du facteur de remplissage de la couche structurée ;
- la figure 8A est une vue schématique d'une sixième variante de filtre interférentiel, et la figure 8B illustre la réponse spectrale d'un tel dispositif de détection pour différentes valeurs du facteur de remplissage de la couche structurée ;
- la figure 9 est une vue schématique en coupe d'un dispositif de détection de rayonnement électromagnétique selon un deuxième mode de réalisation, adapté à la détection multispectrale ;
- les figures 10A à 10H illustrent différentes étapes d'un procédé de réalisation d'un dispositif de détection selon un troisième mode de réalisation ;
- les figures 11A à 11C illustrent différentes étapes d'un procédé de réalisation d'un dispositif de détection selon un quatrième mode de réalisation ;
- les figures 12A à 12E illustrent différentes étapes d'un procédé de réalisation d'un dispositif de détection selon un cinquième mode de réalisation ;
- les figures 13A à 13C illustrent différentes variantes du dispositif de détection.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près.

D'une manière générale, l'invention porte sur un dispositif de détection de rayonnement électromagnétique comportant au moins un détecteur thermique situé dans une cavité avantageusement hermétique. De préférence, le dispositif de détection comporte une matrice de détecteurs thermiques, situés, seul ou à plusieurs, dans une ou plusieurs cavités.

Dans la suite de la description, les détecteurs thermiques sont des bolomètres dont la membrane absorbante est suspendue au-dessus du substrat. La membrane comporte un matériau thermistance dont la conductivité électrique varie en fonction de l'échauffement de la membrane. Cependant, cet exemple est donné à titre illustratif et n'est nullement limitatif. Tout autre type de détecteur thermique peut être utilisé, par exemple des détecteurs pyroélectriques, ferroélectriques, voire des thermopiles.

Le dispositif de détection comporte une structure d'encapsulation qui définit, avec le substrat, la cavité dans laquelle sont situés un ou plusieurs détecteurs thermiques. La structure d'encapsulation comporte une couche mince d'encapsulation qui s'étend au-dessus du ou des détecteurs thermiques, et plus précisément au-dessus de la ou des membranes absorbantes. Elle est réalisée en un matériau transparent au rayonnement à détecter, et présente une épaisseur de l'ordre de quelques centaines de nanomètres à quelques microns. Comme détaillé plus loin, la couche mince d'encapsulation peut s'étendre autour du ou des détecteurs thermiques, c'est-à-dire qu'elle peut définir la bordure périphérique de la cavité. Elle peut en outre s'étendre de manière continue au-dessus de plusieurs détecteurs thermiques. Par couche mince, on entend une couche déposée par les techniques de dépôt de matériau de la microélectronique, dont l'épaisseur est de préférence inférieure à 10µm.

Le dispositif de détection comporte en outre un filtre interférentiel à cavité Fabry-Pérot. Un tel filtre est formé de deux miroirs semi-réfléchissants espacés l'un de l'autre par une couche dite structurée, d'épaisseur d et présentant un indice de réfraction moyen n_{cs}. Un miroir semi-réfléchissant est dit inférieur lorsqu'il est situé du côté de la couche structurée orientée vers le détecteur thermique, ou est dit supérieur lorsqu'il est situé du côté opposé de la couche structurée. Le filtre interférentiel assure la réflexion de longueurs d'onde de la lumière incidente dans la gamme de détection du détecteur thermique, hormis pour une ou plusieurs longueurs d'onde qui sont transmises. La longueur d'onde centrale du pic de transmission de la réponse spectrale du filtre dépend notamment de l'épaisseur optique n_{cs}.d de la couche structurée.

Ainsi, le filtre interférentiel permet au dispositif de détection de détecter un rayonnement électromagnétique de manière sélective, ce qui se traduit par un filtrage des longueurs d'onde du rayonnement incident à l'intérieur d'un domaine spectral, dit de détection, c'est-à-dire un domaine spectral apte à être détecté par le détecteur thermique. Le domaine spectral de détection est, dans la suite de la description, la bande infrarouge LWIR (longueurs d'onde comprises entre 8µm à 14µm) mais le dispositif de détection peut être utilisé dans d'autres domaines spectraux dans l'infrarouge dans lesquels les détecteurs thermiques sont sensibles, comme le THz, le MWIR (entre 3µm et 5µm) ou le SWIR (entre 1µm et 3µm). Dans le but de simplifier le traitement des signaux détectés, on souhaite ici que les filtres interférentiels soient des filtres passe-bande à bande étroite, avec une transmission élevée à l'intérieur de la bande passante et une forte réjection des longueurs d'onde en dehors.

Comme il est décrit en détail plus loin, chaque miroir semi-réfléchissant comporte au moins une couche dite de haut indice réalisée en au moins un matériau diélectrique ou semiconducteur, et avantageusement une couche dite de bas indice réalisée en un milieu dont l'indice de réfraction, ou indice optique, est inférieur à celui du matériau de la couche de haut indice. De préférence, chaque miroir semi-réfléchissant ne comporte qu'une seule couche de haut indice avantageusement séparée de la couche structurée par une couche de bas indice. La couche de haut indice peut être réalisée en un même matériau, ou en un empilement de sous-couches de matériaux différents. La couche de haut indice présente une épaisseur égale à un multiple du rapport d'une longueur d'onde de référence comprise dans un domaine spectral de détection du détecteur thermique sur quatre fois son indice de réfraction. L'épaisseur est ici définie comme la dimension moyenne de la couche de haut indice située en regard du détecteur thermique, suivant une direction orthogonale au plan du substrat. La longueur d'onde de référence est une longueur d'onde prédéfinie comprise dans le domaine spectral de détection. Par exemple, la longueur d'onde de référence peut être égale à 10µm pour le LWIR. La couche de haut indice présente ainsi une fonction optique en formant une lame quart d'onde ou demi onde pour la longueur d'onde de référence. L'indice de réfraction de la couche de haut indice est celui de son matériau diélectrique ou semiconducteur, ou l'indice de réfraction moyen lorsqu'elle comporte plusieurs matériaux différents.

La couche structurée présente une épaisseur sensiblement constante, et est formée d'une alternance, dans un plan parallèle aux miroirs semi-réfléchissants, de portions dites de haut indice réalisées en au moins un matériau diélectrique ou semiconducteur, et de portions dites de bas indice réalisées en un milieu dont l'indice de réfraction est inférieur à celui du matériau des portions de haut indice et du matériau des couches de haut indice. La proportion volumique des portions de haut indice sur le volume total de la couche structurée, dans une zone située en regard, c'est-à-dire à la perpendiculaire, de la membrane absorbante, s'entend comme un facteur de remplissage de la couche structurée. Ainsi, un facteur de remplissage de 1 correspond à une couche continue réalisée dans le matériau de la portion de haut indice. L'indice de réfraction moyen n_{cs} de la couche structurée peut être défini à partir des indices de réfraction du matériau des portions de haut indice et du milieu des portions de bas indice, pondérés par le facteur de remplissage. Les dimensions latérales des portions de haut indice et de bas indice, dans le plan principal (X,Y) du filtre, participent à définir la longueur d'onde centrale du pic de transmission de la réponse spectrale du filtre interférentiel.

Selon l'invention, la couche de haut indice de l'un des miroirs semi-réfléchissants du filtre interférentiel, et de préférence le miroir semi-réfléchissant inférieur, est au moins en partie formée de la couche mince d'encapsulation. En d'autres termes, comme décrit plus loin, la couche de haut indice peut comporter uniquement la couche mince d'encapsulation, et donc être constituée de celle-ci, ou être formée d'un empilement de plusieurs sous-couches dont l'une correspond à la couche mince d'encapsulation. Ainsi, le filtre interférentiel ne repose pas sur la membrane absorbante, au sens où il n'est pas au contact de la membrane. Ainsi, les propriétés de la membrane absorbante sont préservées de toute dégradation liée à un éventuel contact du filtre sur la membrane absorbante. De plus, la couche mince d'encapsulation présente en outre une fonction optique dans la mesure où son épaisseur participe à former une lame quart d'onde ou demi onde de la couche de haut indice.

Le dispositif de détection peut avantageusement être utilisé pour la détection multispectrale. Pour cela, le dispositif de détection comporte une matrice de détecteurs thermiques adaptés à détecter un rayonnement électromagnétique situé dans un même domaine spectral de détection déterminé par les propriétés des membranes absorbantes. Une matrice de filtres interférentiels est disposée en regard de la matrice de détection, à raison d'un filtre par détecteur. La couche mince d'encapsulation est avantageusement commune à la ou aux cavités qui logent la matrice de détecteurs, de sorte que la même couche mince d'encapsulation s'étend au-dessus de chaque détecteur thermique. Elle forme la couche de haut indice, ou l'une des sous-couches, de l'un des miroirs semi-réfléchissants de chaque filtre interférentiel. De préférence, les miroirs semi-réfléchissants et la couche structurée des différents filtres interférentiels sont respectivement coplanaires. En d'autres termes, les couches structurées des différents filtres sont de préférence coplanaires, les miroirs supérieurs sont de préférence coplanaires, et les miroirs inférieurs sont de préférence coplanaires. Les filtres interférentiels se distinguent les uns des autres essentiellement par les dimensions latérales des portions de haut et de bas indice des couches structurées, et donc par le facteur de remplissage, qui définissent la longueur d'onde centrale des réponses spectrales propres à chaque filtre interférentiel.

La figure 2A est une vue schématique en coupe d'un dispositif de détection d'un rayonnement électromagnétique selon un premier mode de réalisation.

On définit ici et pour la suite de la description un repère orthonormé tridimensionnel (X,Y,Z), où le plan (X,Y) est sensiblement parallèle au plan d'un substrat du dispositif de détection 1, l'axe Z étant orienté suivant une direction sensiblement orthogonale au plan du substrat 2. Ainsi, les termes « vertical » et « verticalement » s'étendent comme étant relatifs à une orientation suivant l'axe Z, et les termes « inférieur » et « supérieur » s'étendent comme étant relatifs à un positionnement croissant lorsqu'on s'éloigne du substrat 2 suivant l'axe Z.

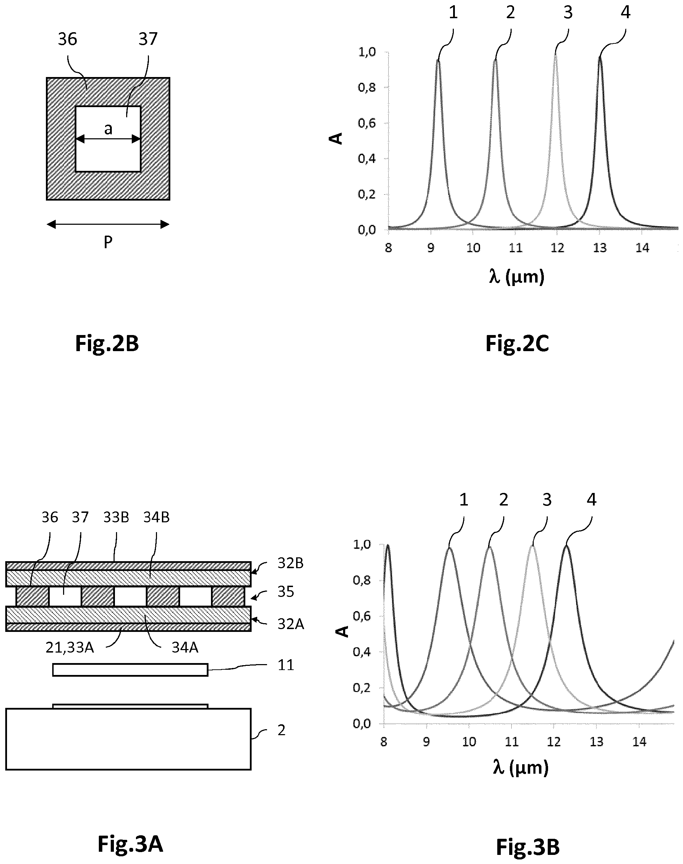

Le dispositif de détection de rayonnement électromagnétique est adapté à détecter un rayonnement infrarouge ou térahertz. Il comporte au moins un détecteur thermique, et de préférence une matrice de détecteurs thermiques électriquement reliés à un circuit de lecture. La figure 2 est une vue partielle du dispositif de détection 1 et ne représente qu'un seul détecteur thermique.

Le dispositif de détection 1 comprend un substrat 2, réalisé à base de silicium, comprenant un circuit électronique de lecture (non représenté) réalisé en technologie CMOS permettant d'appliquer un signal de commande aux détecteurs thermiques et de lire les signaux de détection générés par ceux-ci en réponse à une détection du rayonnement électromagnétique d'intérêt. Le circuit de lecture peut comporter une partie inférieure formée de dispositifs électroniques de type MOS, par exemple des transistors, diodes, condensateurs, adaptés à la mise en oeuvre des différentes fonctions électroniques du circuit de lecture. Il comporte en outre plusieurs niveaux d'interconnexions électriques assurant les liaisons électriques entre les différents dispositifs MOS et les détecteurs thermiques, ainsi que la liaison électrique à au moins un plot de connexion électrique du circuit de lecture avec l'extérieur du dispositif de détection.

Sur le substrat 2 repose un micro-bolomètre 10 qui comporte une membrane 11 adaptée à absorber le rayonnement à détecter dans le domaine spectral de détection. La membrane absorbante 11 est isolée thermiquement et suspendue au-dessus du substrat 2 par des éléments de maintien et d'isolation thermique tels que des piliers d'ancrage 12 associés à des bras d'isolation thermique (non représentés). La membrane absorbante 11 est espacée du substrat 2 d'une distance typiquement comprise entre 1µm et 5µm, de préférence 2µm quand les détecteurs sont conçus pour la détection d'un rayonnement infrarouge compris dans le LWIR. Un réflecteur 13 est situé sur le substrat 2, et disposé en regard de la membrane absorbante 11.

Le dispositif de détection 1 comporte une structure d'encapsulation 20, ou capsule, qui définit, avec le substrat 2, une cavité 3 avantageusement hermétique à l'intérieur de laquelle se trouve le détecteur thermique 10. La structure d'encapsulation 20 est formée d'une couche mince d'encapsulation 21 déposée de sorte qu'elle comporte une paroi supérieure 22 sensiblement plane qui s'étend au-dessus du détecteur 10, à une distance non nulle de la membrane suspendue 11, par exemple comprise entre 0,5µm et 5µm, de préférence 1,5µm. Elle comporte en outre une paroi latérale 23, éventuellement périphérique de manière à entourer le détecteur thermique dans le plan (X,Y), qui s'étend à partir de la paroi supérieure 22 et repose sur le substrat 2. La couche mince d'encapsulation 21 s'étend donc dans cet exemple de manière continue au-dessus et autour du détecteur thermique de manière à définir la cavité 3 avec le substrat 2. Comme détaillé plus loin, dans le cas où la couche mince d'encapsulation 21 comporte un orifice traversant formant un évent de libération, la structure d'encapsulation 20 peut comporter au moins une couche de scellement, recouvrant la couche mince d'encapsulation 21 de manière à obturer l'évent, de manière à assurer ainsi l'herméticité de la cavité. Ainsi, la structure d'encapsulation définit une cavité qui loge le ou les détecteurs thermiques.

Le dispositif de détection comporte une structure de filtrage optique 30 comportant au moins un filtre interféromètre 31 à cavité Fabry-Pérot. Le filtre interférentiel 31 est situé en regard du détecteur thermique 10, plus précisément en regard de la membrane absorbante 11, au niveau de la structure d'encapsulation 30 et n'est donc pas en contact avec la membrane absorbante 11. Le filtre interférentiel 31 peut transmettre une seule bande spectrale, comprise dans le domaine spectral de détection. Dans le cas d'une matrice de détecteurs thermiques, le dispositif de filtrage optique 30 comporte une pluralité de filtres interféromètres 31 à cavité Fabry-Pérot disposés en regard des détecteurs thermiques, par exemple à raison d'un filtre 31 par détecteur 10. Les filtres 31 sont alors structurés de sorte que les longueurs d'onde centrales des réponses spectrales sont différentes les unes par rapport aux autres.

Le filtre interférentiel 31 comporte un empilement de couches formant un miroir semi-réfléchissant inférieur 32A et un miroir semi-réfléchissant supérieur 32B, espacé l'un de l'autre par une couche structurée 35. Chaque miroir semi-réfléchissant 32A, 32B comporte au moins une couche dite de haut indice de réfraction, et peut comporter, comme illustré sur la figure 2, une couche dite de bas indice de réfraction, située entre la couche de haut indice et la couche structurée. De préférence, au moins un miroir semi-réfléchissant comporte une telle couche de bas indice, de sorte que la réponse spectrale du filtre interférentiel présente un pic de transmission suffisamment fin et une bonne réjection.

Les couches de haut indice 33A, 33B sont réalisées en au moins un matériau diélectrique ou semiconducteur qui peut être choisi parmi le silicium, le germanium, un alliage de silicium et de germanium SiₓGe₁₋ₓ, et le carbure de silicium SiₓC₁₋ₓ, par exemple amorphe. Leurs épaisseurs sont telles que chaque couche de haut indice 33A, 33B forme avantageusement une lame quart d'onde vis-à-vis d'une longueur d'onde de référence comprise dans le domaine spectral de détection, par exemple 10µm. A titre d'exemple, pour un domaine spectral de détection correspondant au LWIR, l'épaisseur des couches de haut indice 33A, 33B peut être de 0,73µm environ pour du silicium amorphe d'indice optique de 3,5. Comme détaillé plus loin, chaque couche de haut indice 33A, 33B peut être formée d'un empilement de plusieurs sous-couches de matériaux différents en contact les unes des autres. Les matériaux sont choisis de sorte que l'empilement de sous-couches soit optiquement équivalent, en termes de chemin optique, à une seule couche de haut indice, l'indice de réfraction moyen est alors fonction des indices de réfraction propres à chaque matériau des sous-couches.

Chaque miroir semi-réfléchissant 32A, 32B comporte ici une couche de bas indice 34A, 34B, réalisée en un milieu présentant un indice de réfraction inférieur à celui de la couche de haut indice 33A, 33B, avec un contraste d'indice de préférence supérieur à 1,5. Ce milieu peut être choisi parmi un matériau diélectrique ou semiconducteur, du gaz ou du vide. Dans le cas du gaz et du vide, la couche de bas indice 34A, 34B correspond alors à une zone de gaz ou de vide située entre la couche structurée 35 et la couche de haut indice 33A, 33B, d'épaisseur sensiblement constante. L'épaisseur des couches de bas indice 34A, 34B est telle que chaque couche 34A, 34B forme avantageusement une lame quart d'onde vis-à-vis de la longueur d'onde de référence. A titre d'exemple, pour le domaine spectral de détection correspondant au LWIR, l'épaisseur des couches de bas indice peut être de 2,5µm environ pour de l'air.

Un fort contraste d'indice, de préférence supérieur ou égal à 1,5, entre les indices de réfraction de la couche de haut indice 33A, 33B et de la couche de bas indice 34A, 34B permet d'obtenir un pic de transmission fin centré sur une longueur d'onde centrale, tout en repoussant les ordres supérieurs à l'ordre 1 de la cavité Fabry-Pérot hors du domaine spectral de détection.

Entre les deux miroirs semi-réfléchissants 32A, 32B s'étend une couche structurée 35, formant l'espaceur de la cavité Fabry-Pérot. Elle comporte des portions dites de haut indice 36 réalisées en au moins un matériau diélectrique ou semiconducteur, et des portions de bas indice 37 réalisées en un milieu d'indice de réfraction inférieur à celui du matériau des portions de haut indice. Les portions de haut indice 36 et les portions de bas indice 37 alternent dans le plan (X,Y) du filtre, c'est-à-dire dans un plan parallèle aux plans des miroirs semi-réfléchissants. Elles sont agencées de manière à former un motif, ou structuration, qui se répète de manière périodique ou non. Ainsi, chaque portion d'un premier milieu est située entre deux portions du deuxième milieu dans le plan (X,Y) du filtre, de sorte que les portions 36, 37 sont agencées mutuellement de manière alternée. Il ne s'agit donc pas d'une superposition de couches de deux milieux différents suivant l'axe Z.

Le matériau des portions de haut indice 36 peut être un matériau diélectrique ou semiconducteur, et est de préférence identique à celui des couches de haut indice des miroirs semi-réfléchissants. Il peut ainsi s'agir de silicium par exemple amorphe ou de germanium. Le milieu des portions de bas indice est de préférence un gaz ou du vide, mais peut être un matériau diélectrique ou semiconducteur. La différence entre l'indice de réfraction du matériau de haut indice et celui du milieu de bas indice est de préférence supérieure ou égale à 1,5. Ainsi, le filtre interférentiel ne comporte pas de matériau métallique susceptible d'affecter la détection du rayonnement infrarouge ou térahertz.

La couche structurée 35 présente une épaisseur sensiblement constante, de sorte que les portions de haut indice 36 et les portions de bas indice 37 présentent sensiblement la même épaisseur. L'épaisseur peut être de l'ordre de 2µm, pour limiter les résonances parasites dans la plage de fonctionnement du dispositif de détection multispectrale.

Les portions de haut indice 36 et les portions de bas indice 37 sont agencées mutuellement de manière à former un motif élémentaire, qui se répète périodiquement ou non selon un ou deux axes dans le plan (X,Y). Les motifs peuvent être périodiques suivant deux dimensions, et prendre une forme quelconque de plots carrés, circulaires ou autres. Ils sont alors adaptés à réaliser un filtrage d'une lumière non polarisée ou présentant deux polarisations. Les motifs peuvent en variante être périodiques suivant une seule dimension, et prendre alors la forme de fentes. Ils sont alors adaptés à réaliser un filtrage d'une lumière présentant une seule polarisation.

La longueur d'onde centrale du pic de transmission de la réponse spectrale du filtre interférentiel 31 dépend notamment des paramètres dimensionnels de la couche structurée 35, à savoir les dimensions latérales des portions de haut indice 36 et de bas indice 37, la période de l'agencement des motifs, ainsi que de la valeur des indices de réfraction de ces milieux. Les dimensions des motifs de la couche structurée 35, en termes de période et de dimensions latérales, dans le plan principal (X,Y) de la couche structurée 35, peuvent être inférieures à une valeur d'une longueur d'onde centrale du pic de transmission de la réponse spectrale du filtre à l'ordre 1.

La couche mince d'encapsulation 21 de la structure d'encapsulation 20 forme ici la couche de haut indice 33A de l'un desdits miroirs semi-réfléchissants, ici le miroir semi-réfléchissant inférieur 32A. Le filtre interférentiel 31 ne repose alors pas directement sur la membrane absorbante 11 mais est espacé de celle-ci. La présence du filtre 31 n'affecte donc pas les performances propres du détecteur thermique, notamment le temps de réponse du détecteur qui dépend notamment de l'inertie thermique de la membrane absorbante, celle-ci étant dégradée lorsque le filtre interférentiel repose directement sur la membrane comme dans l'exemple de l'art antérieur décrit précédemment.

Il est avantageux que l'un et/ou l'autre des miroirs semi-réfléchissants 32A, 32B ne comportent qu'une seule couche de haut indice 33A, 33B, et non pas plusieurs couches de haut indice en alternance avec des couches de bas indice, comme c'est le cas habituellement des miroirs diélectriques multicouches. En effet, comme il sera décrit par la suite, on simplifie le procédé de réalisation tout en obtenant des filtres interférentiels présentant une sélectivité spectrale élevée et une forte réjection.

La figure 2B est une vue de dessus d'un exemple de motif élémentaire formé par une portion de haut indice et par une portion de bas indice de la couche structurée, et la figure 2C illustre les réponses spectrales du filtre pour différentes valeurs du facteur de remplissage de la couche structurée.

Comme mentionné précédemment, le facteur de remplissage f est défini comme le rapport entre le volume occupé par les portions de haut indice 36 sur le volume total de la couche structurée 35, en particulier dans une zone de la couche structurée située en regard, c'est-à-dire à la perpendiculaire, de la membrane absorbante. Par ailleurs, la réponse spectrale est ici caractérisée par la valeur du coefficient de transmission du filtre en fonction de la longueur d'onde du rayonnement incident et par la largeur à mi-hauteur du pic de transmission, ainsi que par la réjection, dans le domaine spectral de détection correspondant ici au LWIR (8-14µm). La réjection est définie ici comme le rapport de la valeur maximale de transmission dans la bande passante du filtre sur la valeur minimale de transmission hors de la bande passante, dans le domaine spectral de détection considéré.

Dans l'exemple de la figure 2B, le motif élémentaire formé par les portions de haut indice 36 et les portions de bas indice 37 de la couche structurée 35 se présente sous la forme d'un orifice traversant 37 à section carrée dans le plan (X,Y) de côté « a », entouré par une portion de haut indice 36. La couche structurée 35 présente ainsi une forme de grille réalisée dans le matériau des portions de haut indice dans laquelle les orifices traversants forment les portions de bas indice 37, celles-ci étant espacées les unes des autres d'une période P. Comme mentionné précédemment, l'orifice traversant peut présenter différentes formes de section dans le plan (X,Y).

Chaque miroir semi-réfléchissant 32A, 32B comporte une couche de haut indice 33A, 33B en silicium amorphe d'une épaisseur de 0,8µm environ et une couche de bas indice 34A, 34B de vide d'une épaisseur de 2,5µm, formant l'une et l'autre une lame quart d'onde pour une longueur d'onde de référence de 10µm. La couche structurée 35 présente une épaisseur de 1,9µm environ et est formée de portions de haut indice 36 en silicium amorphe et de portions de bas indice 37 de vide. La figure 2C illustre la réponse spectrale du filtre interférentiel pour différentes valeurs de la dimension latérale « a » des portions de bas indice 37, et le tableau ci-dessous indique la valeur correspondante de la longueur d'onde centrale du pic de transmission.

| Ref | 1 | 2 | 3 | 4 |
|---|---|---|---|---|
| P (µm) | 2 | 2 | 2 | 2 |
| a (µm) | 1,5 | 1,2 | 0,75 | 0 |
| λ_{c} (µm) | 9 | 10,5 | 12 | 13 |

Dans le domaine spectral de détection correspondant au LWIR, chaque réponse spectrale présente ici un pic de transmission fin avec une forte réjection hors de la bande passante du filtre.

Les figures 3A et 3B illustrent respectivement un dispositif de détection comportant un filtre interférentiel selon une première variante du premier mode de réalisation, et les réponses spectrales associées à différentes valeurs du facteur de remplissage de la couche structurée.

Dans cet exemple, le filtre interférentiel 31 se distingue de celui illustré sur la figure 2A essentiellement en ce que chaque miroir semi-réfléchissant 32A, 32B comporte une couche de bas indice 34A, 34B réalisée en un matériau diélectrique ou semiconducteur autre que l'air ou le vide. Le contraste d'indice de chaque miroir semi-réfléchissant entre les couches de haut et bas indice est ainsi diminué par rapport à celui des miroirs de la figure 2A. Ainsi, à titre illustratif, les couches de bas indice 34A, 34B peuvent être formées de sulfure de zinc ZnS dont l'indice de réfraction est de 2.2 dans le domaine spectral de détection 8-14µm. Pour une même période P des motifs et différentes valeurs de la largeur a des portions de bas indice, on obtient des filtres dont la valeur de la longueur d'onde centrale est indiquée dans le tableau ci-dessous.

| Ref | 1 | 2 | 3 | 4 |
|---|---|---|---|---|
| P (µm) | 2 | 2 | 2 | 2 |
| a (µm) | 1,5 | 1,2 | 0,75 | 0 |
| λ_{c} (µm) | 9,5 | 10,5 | 11,5 | 12,5 |

Les pics de transmission s'élargissent et la réjection se dégrade, notamment du fait de la présence de pics secondaires de transmission, notamment causés par les ordres supérieurs à l'ordre 1 des cavités Fabry-Pérot. Dans le but de maintenir une réponse spectrale correcte, en termes de largeur de pic de transmission et de réjection, le contraste d'indice entre les couches de haut et de bas indice des miroirs semi-réfléchissants est avantageusement supérieur ou égal à 1,5, et de préférence choisi pour être le plus élevé possible.

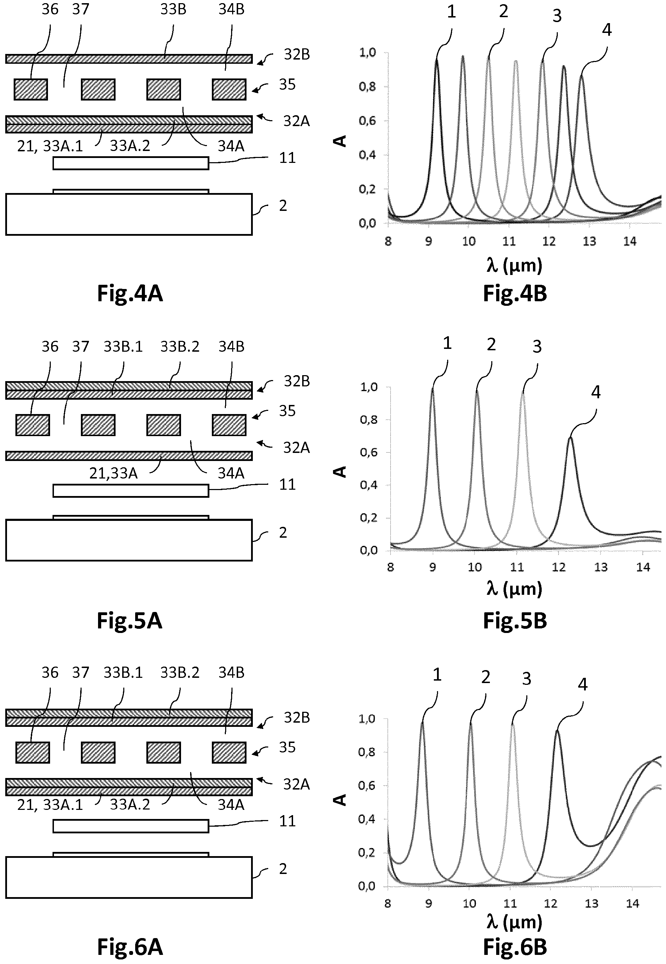

Les figures 4A et 4B illustrent respectivement un dispositif de détection comportant un filtre interférentiel selon une deuxième variante du premier mode de réalisation, et les réponses spectrales associées à différentes valeurs du facteur de remplissage de la couche structurée.

Dans cet exemple, le filtre interférentiel 31 se distingue de celui illustré sur la figure 2A essentiellement en ce que la couche de haut indice du miroir semi-réfléchissant inférieur 32A est formée de l'empilement, suivant l'axe Z, d'au moins deux sous-couches 33A.1, 33A.2 en des matériaux différents, ces matériaux étant diélectriques ou semiconducteurs, et présentant un indice optique supérieur à celui du milieu des couches de bas indice 34A, 34B et du milieu des portions de bas indice 37 de la couche structurée. La deuxième sous-couche 33A.2 recouvre et est au contact de la première sous-couche 33A.1, celle-ci étant ici la couche mince d'encapsulation 21. La couche de haut indice formée de plusieurs matériaux de haut indice est alors optiquement équivalente à une seule couche de haut indice. L'épaisseur de la couche de haut indice est avantageusement telle qu'elle forme une couche trois quart d'onde. Ainsi, le filtre présente une réponse spectrale sélective et une forte réjection.

A titre illustratif, la couche de haut indice inférieure est formée d'une sous-couche 33A.1 de silicium amorphe de 0,73µm environ d'épaisseur, recouverte d'une sous-couche 33A.2 de germanium de 1,25µm environ, et la couche de haut indice supérieure 33B est en silicium amorphe de 0,73µm environ d'épaisseur, les couches de haut indice étant séparées de la couche structurée 35 par des couches de bas indice 34A, 34B d'air de 2,5µm environ d'épaisseur. Pour une même période P des motifs et différentes valeurs de la largeur a des portions de bas indice, on obtient des filtres dont la valeur de la longueur d'onde centrale est indiquée dans le tableau ci-dessous.

| Ref | 1 | 2 | 3 | 4 |
|---|---|---|---|---|
| P (µm) | 2 | 2 | 2 | 2 |
| a (µm) | 1,5 | 1,2 | 0,75 | 0 |
| λ_{c} (µm) | 9 | 10,5 | 12 | 13 |

Par rapport aux réponses spectrales illustrées sur la figure 2C, les pics de transmission restent fins et la réjection est élevée. Seul le taux de transmission diminue légèrement lorsque la largeur a des portions de bas indice est proche ou égal à 0 (facteur de remplissage proche ou égal à 1).

Les figures 5A et 5B illustrent respectivement un dispositif de détection comportant un filtre interférentiel selon une troisième variante du premier mode de réalisation, et les réponses spectrales associées à différentes valeurs du facteur de remplissage de la couche structurée.

Dans cet exemple, le filtre interférentiel 31 se distingue de celui illustré sur la figure 4A essentiellement en ce que seule la couche de haut indice du miroir semi-réfléchissant supérieur 32B, et non plus le miroir inférieur 32A, est formée de l'empilement, suivant l'axe Z, d'au moins deux sous-couches 33B.1, 33B.2 en des matériaux différents, ces matériaux étant diélectriques ou semiconducteurs, et présentant un indice optique supérieur à celui du milieu de la couche de bas indice 34B et du milieu des portions de bas indice 37 de la couche structurée. La couche mince d'encapsulation 21 forme ici l'unique couche de haut indice 33A du miroir inférieur 32A. Ainsi, à titre illustratif, la couche de haut indice supérieure est formée d'une sous-couche 33B.1 de silicium amorphe de 0,73µm environ d'épaisseur recouverte d'une sous-couche 33B.2 de germanium de 1,25µm environ d'épaisseur, et la couche de haut indice inférieure 33A est en silicium amorphe de 0,73µm environ d'épaisseur, les couches de haut indice étant séparées de la couche structurée 35 par des couches de bas indice 34A, 34B d'air de 2,5µm d'épaisseur. Pour une même période P des motifs et différentes valeurs de la largeur a des portions de bas indice, on obtient des filtres dont la valeur de la longueur d'onde centrale est indiquée dans le tableau ci-dessous.

| Ref | 1 | 2 | 3 | 4 |
|---|---|---|---|---|
| P (µm) | 2 | 2 | 2 | 2 |
| a (µm) | 1,5 | 1,2 | 0,75 | 0 |
| λ_{c} (µm) | 9 | 10,5 | 12 | 13 |

Par rapport aux réponses spectrales illustrées sur la figure 4B, les pics de transmission restent fins et la réjection est élevée. Lorsque la largeur a des portions de bas indice est proche ou égal à 0 (facteur de remplissage proche ou égal à 1), le pic de transmission présente une valeur maximale diminuée et une largeur à mi-hauteur augmentée.

Les figures 6A et 6B illustrent respectivement un dispositif de détection comportant un filtre interférentiel selon une quatrième variante du premier mode de réalisation, et les réponses spectrales associées à différentes valeurs du facteur de remplissage de la couche structurée.

Dans cet exemple, le filtre interférentiel 31 se distingue de ceux illustrés sur les figures 4A et 5A essentiellement en ce que les couches de haut indice des miroirs semi-réfléchissants inférieur 32A et supérieur 32B sont formées toutes deux de l'empilement, suivant l'axe Z, d'au moins deux sous-couches en des matériaux différents, ces matériaux étant diélectriques ou semiconducteurs, et présentant un indice optique supérieur à celui du milieu de l'éventuelle couche de bas indice et du milieu des portions de bas indice de la couche structurée. La couche mince d'encapsulation 21 forme la première sous-couche 33A.1 de haut indice du miroir inférieur 32A. Ainsi, à titre illustratif, les couches de haut indice des miroirs semi-réfléchissants 32A, 32B sont formées chacune d'une première sous-couche 33A.1, 33B.1 en silicium amorphe de 0,73µm environ d'épaisseur recouverte d'une deuxième sous-couche 33A.2, 33B.2 de germanium de 1,25µm environ. Elles sont séparées de la couche structurée 35 par des couches de bas indice 34A, 34B d'air de 2,5µm d'épaisseur. Pour une même période P des motifs et différentes valeurs de la largeur a des portions de bas indice, on obtient des filtres dont la valeur de la longueur d'onde centrale est indiquée dans le tableau ci-dessous.

| Ref | 1 | 2 | 3 | 4 |
|---|---|---|---|---|
| P (µm) | 2 | 2 | 2 | 2 |
| a (µm) | 1,6 | 1,3 | 1 | 0,5 |
| λ_{c} (µm) | 9 | 10 | 11 | 12 |

Par rapport aux réponses spectrales illustrées sur les figures 4B et 5B, les pics de transmission restent fins mais la réjection diminue, notamment du fait de la présence de rebonds qui apparaissent aux limites du domaine spectral de détection 8-14µm.

D'une manière générale, il est avantageux que les couches de haut indice et les couches de bas indice présentent une épaisseur telle qu'elles forment une lame quart d'onde ou un multiple impair d'une lame quart d'onde. On obtient ainsi un seul pic de transmission dans le domaine spectral de détection, dont la valeur de la longueur centrale de détection est ajustable en fonction des dimensions latérales de la couche structurée.

L'une et/ou l'autre des couches de haut indice peuvent également présenter une épaisseur telle qu'elles forment une lame demi-onde ou un multiple pair d'une lame demi-onde. On obtient ainsi un pic de transmission ou une bande large de transmission dans le domaine spectral de détection, en fonction des dimensions latérales des portions de haut et de bas indice de la couche structurée. Un pic de transmission présente ici une largeur à mi-hauteur inférieure ou égale au micron environ, alors qu'une bande large de transmission présente une largeur à mi-hauteur supérieure au micron, par exemple égale à 2 voire 3 microns.

L'une et/ou l'autre des couches de bas indice peuvent également présenter une épaisseur telle qu'elles forment une lame demi-onde ou un multiple pair d'une lame demi-onde. On obtient ainsi plusieurs pics de transmission distincts dans le domaine spectral de détection, avec une forte réjection.

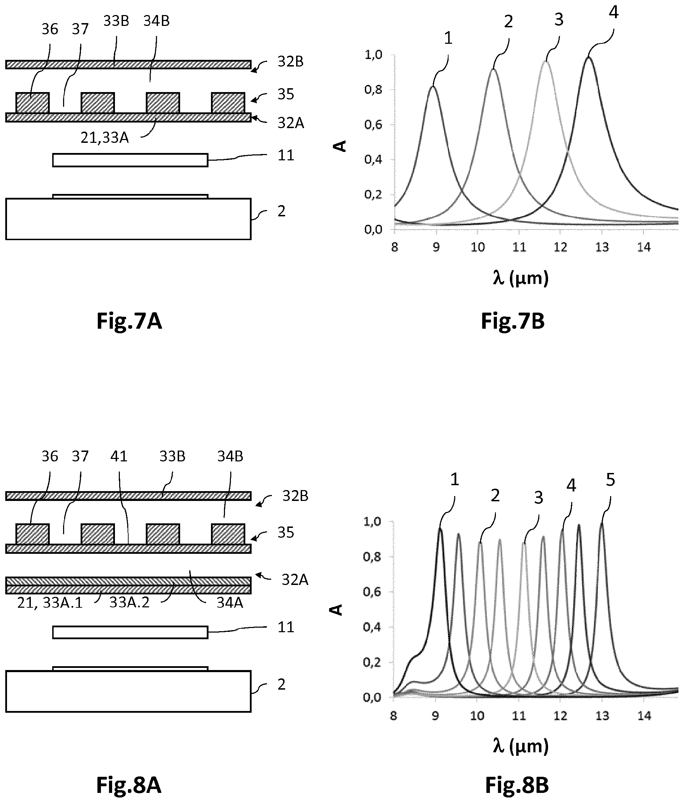

Les figures 7A et 7B illustrent respectivement un dispositif de détection comportant un filtre interférentiel selon une cinquième variante du premier mode de réalisation, et les réponses spectrales associées à différentes valeurs du facteur de remplissage de la couche structurée.

Dans cet exemple, le filtre interférentiel 31 se distingue de celui illustré sur la figure 2A essentiellement en ce que les portions de haut indice 36 de la couche structurée 35 reposent sur la couche de haut indice 33A du miroir semi-réfléchissant inférieur 32A. Le miroir semi-réfléchissant inférieur 32A ne comporte alors pas de couche de bas indice, et le miroir semi-réfléchissant supérieur 32B comporte une couche de bas indice 34B.

Ainsi, à titre illustratif, le miroir semi-réfléchissant inférieur 32A est formé d'une seule couche de haut indice 33A en silicium amorphe de 0,8µm d'épaisseur, sur laquelle repose la couche structurée 35 formée de portions de haut indice 36 en silicium amorphe et de portions de bas indice 37 d'air, ces portions étant au contact de la couche de haut indice 33A. Le miroir supérieur 32B est formé de la couche de bas indice d'air 34B et de la couche de haut indice 33B en silicium amorphe. L'épaisseur du miroir supérieur 32B peut être diminuée, de sorte que la couche de haut indice 33B est ici de 0,45µm et la couche de bas indice 34B de 1,70µm. La couche structurée 35 présente ici une épaisseur de 1,27µm. Pour une même période P des motifs et différentes valeurs de la largeur a des portions de bas indice, on obtient des filtres dont la valeur de la longueur d'onde centrale est indiquée dans le tableau ci-dessous. Dans cet exemple, la configuration à P=2µm et a=1,3µm se distingue des autres configurations dans la mesure où la couche structurée 35 prend la forme de plots de haut indice 36 de section carrée de dimension latérale « a », espacée de manière périodique des autres portions 36 d'un pas P.

| Ref | 1 | 2 | 3 | 4 |
|---|---|---|---|---|
| P (µm) | 2 | 2 | 2 | 2 |
| a (µm) | 1,3 | 1,5 | 1,2 | 0,75 |
| λ_{c} (µm) | 9 | 10,5 | 12 | 13 |

Les réponses spectrales présentent des pics de transmission élargis avec un taux de transmission compris entre 0,8 et 1 environ, qui diminue pour les plus petites longueurs d'onde. Dans cet exemple, la distance entre le réflecteur et la membrane absorbante 11 est réduite de 1,8µm à ici 1µm environ, ce qui permet de réduire la largeur de bande de transmission et d'augmenter le taux de transmission d'une valeur allant jusqu'à 25%.

Lorsqu'un miroir semi-réfléchissant ne comporte pas de couche de bas indice et que la couche structurée est au contact de la couche de haut indice, il est avantageux, en termes de qualité de réponse spectrale, que ce soit le miroir inférieur et non pas le miroir supérieur. Par ailleurs, en variante (non représentée), le miroir inférieur peut comporter une couche de bas indice séparant la couche de haut indice de la couche structurée, et le miroir supérieur peut ne pas comporter de couche de bas indice, de sorte que la couche structurée serait alors en contact avec la couche de haut indice du miroir supérieur.

Les figures 8A et 8B illustrent respectivement un dispositif de détection comportant un filtre interférentiel selon une sixième variante du premier mode de réalisation, et les réponses spectrales associées à différentes valeurs du facteur de remplissage de la couche structurée.

Dans cet exemple, le miroir semi-réfléchissant inférieur 32A comporte une couche de haut indice formée de deux sous-couches réalisées en des matériaux différents l'un de l'autre, ici une sous-couche 33A.1 de silicium amorphe de 0,73µm d'épaisseur, recouverte par une deuxième sous-couche 33A.2 de germanium de 1,45µm d'épaisseur, et une couche de bas indice 34A d'air de 2,37µm d'épaisseur. La couche structurée 35 comporte une alternance de portions de haut indice 36 de silicium amorphe, de 1,36µm environ d'épaisseur, et de portions de bas indice 37 d'air, les portions de bas indice n'étant pas traversantes de sorte que les portions de haut indice 36 reposent sur une couche continue de haut indice 41, ici du silicium amorphe de 0,73µm d'épaisseur. Enfin, le miroir supérieur 32B comporte une couche de haut indice 33B en un seul matériau, ici du silicium amorphe de 0,73µm d'épaisseur et une couche de bas indice 34B, ici d'air de 2,37µm d'épaisseur. Pour une même période P des motifs et différentes valeurs de la largeur a des portions de bas indice, on obtient des filtres dont la valeur de la longueur d'onde centrale est indiquée dans le tableau ci-dessous. Dans cet exemple, les configurations à P=2µm, a=1,2µm (f=0,36), et P=2µm, a=1.5µm (f=0,56) se distingue des autres configurations dans la mesure où la couche structurée prend la forme de plots de haut indice de section carrée de dimension latérale « a », espacée de manière périodique des autres portions d'un pas P.

| Ref | 1 | 2 | 3 | 4 | 5 |
|---|---|---|---|---|---|
| P (µm) | 2 | 2 | 2 | 2 | 2 |
| a (µm) | 1,2 | 1,5 | 1,35 | 1 | 0 |
| λ_{c} (µm) | 9 | 10 | 11 | 12 | 13 |

Cette configuration est avantageuse dans la mesure où chaque pic de transmission est fin, le taux de transmission élevé ainsi que la qualité de réjection.

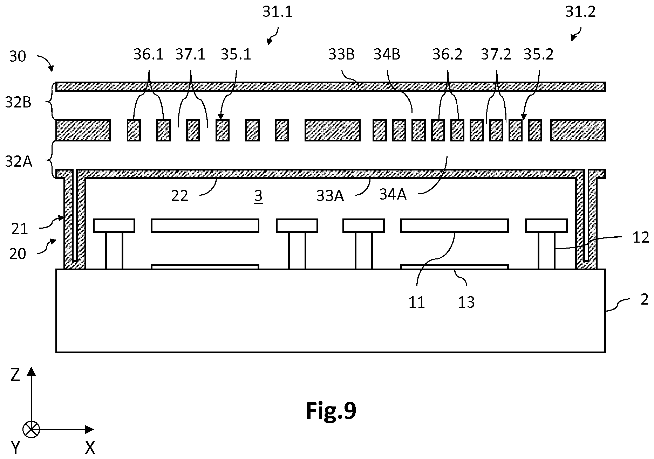

La figure 9 est une vue schématique en coupe d'un dispositif de détection multispectrale, comportant une matrice de détecteurs thermiques situés seul ou à plusieurs dans une cavité hermétique, et une matrice de filtres interférentiels à cavité Fabry-Pérot agencés chacun en regard d'un détecteur thermique. Les détecteurs thermiques sont adaptés à fonctionner dans le même domaine spectral de détection, ici le LWIR. Aussi les différentes membranes absorbantes présentent des propriétés optoélectroniques sensiblement identiques.

Les filtres 31.1, 31.2 sont tels que les longueurs d'onde centrales λ_{c1}, λ_{c2} des réponses spectrales sont différentes les unes des autres. Deux filtres différents 31.1, 31.2 sont illustrés ici à titre d'exemple, mais le dispositif de détection peut comporter plusieurs ensembles d'un ou plusieurs filtres identiques, les filtres étant différents d'un ensemble de filtres à l'autre, selon le nombre de réponses spectrales distinctes dans le domaine spectral de détection.

Les filtres interférentiels 31.1, 31.2 sont adjacents et sensiblement coplanaires les uns des autres. En particulier, la couche de haut indice inférieure 33A et la couche de haut indice supérieure 33B sont respectivement coplanaires d'un filtre à l'autre, et sont de préférence communes à tous les filtres. La couche mince d'encapsulation 21 est de préférence commune à tous les filtres 31.1, 31.2. Les couches structurées 35.1, 35.2 sont ici coplanaires et présentent sensiblement la même épaisseur, tout comme les couches de bas indice 34A, 34B.

Les filtres interférentiels 31.1, 31.2 se distinguent entre eux essentiellement en ce qui concerne les dimensions latérales des portions de haut indice 36.1, 36.2 et de bas indice 37.1, 37.2 des couches structurées 35.1, 35.2, qui définissent la valeur des longueurs d'onde centrales λ_{c1}, λ_{c2} de chaque réponse spectrale.

Dans cet exemple où plusieurs détecteurs thermiques sont disposés dans la même cavité hermétique 3, la couche mince d'encapsulation 21, et en particulier sa paroi supérieure 22, s'étend au-dessus desdits détecteurs de manière continue. La couche mince d'encapsulation, en particulier sa paroi supérieure 22, forme ici la couche de haut indice inférieure 33A, ou l'une de ses sous-couches, des filtres interférentiels 31.1, 31.2.

Chaque filtre 31.1, 31.2 est de préférence positionné à une distance de la membrane absorbante 11 du détecteur en regard, inférieure à la dimension latérale d'un pixel (surface dans le plan (X,Y) du détecteur thermique), de manière à éviter le cross-talk entre pixels adjacents, c'est-à-dire de manière à éviter qu'un rayonnement transmis par un filtre interférentiel ne soit détecté par un détecteur thermique voisin du détecteur situé en regard du filtre en question.

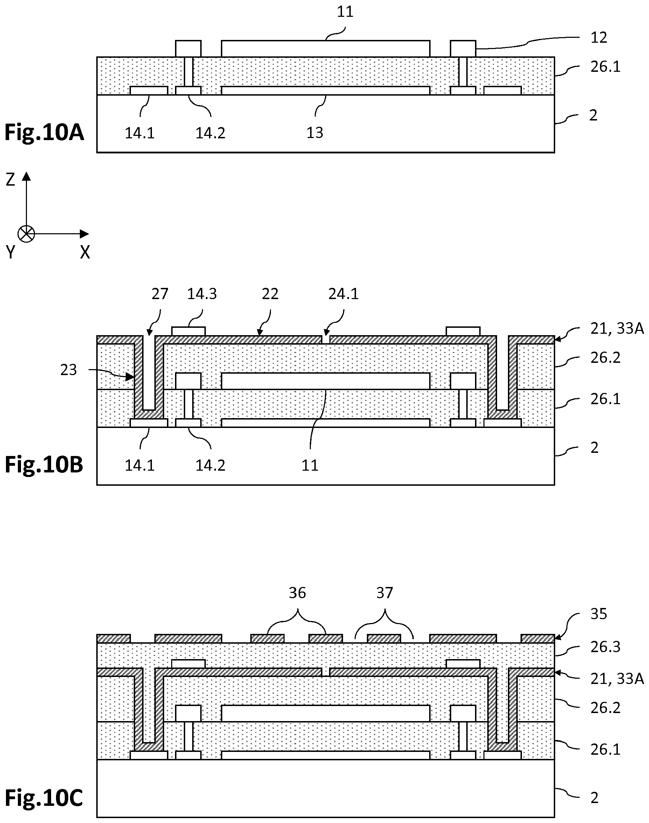

Les figures 10A à 10H illustrent différentes étapes d'un procédé de réalisation du dispositif selon un troisième mode de réalisation. Dans cet exemple, la couche mince d'encapsulation 21 forme la couche de haut indice 33A du miroir semi-réfléchissant inférieur 32A, et la couche de haut indice 33B du miroir semi-réfléchissant supérieur 32B comporte une couche de scellement 33B.2.

En référence à la figure 10A, on réalise sur un substrat 2 une matrice de détecteurs thermiques 10, connectés chacun à un circuit électronique (par exemple CMOS) prévu pour alimenter et mesurer les signaux délivrés par les détecteurs. Les détecteurs thermiques 10 sont par exemple des micro-bolomètres, comportant chacun une membrane 11 apte à absorber le rayonnement à détecter, suspendue au-dessus du substrat 2 et isolée thermiquement de celui-ci par des piliers d'ancrage 12 et des bras de maintien et d'isolation thermique (non représentés). L'obtention de membranes suspendues 11 est classiquement obtenue par des techniques de micro-usinage de surface consistant à réaliser les membranes absorbantes 11 sur une première couche sacrificielle 26.1 qui est éliminée en fin de procédé. Chaque membrane absorbante 11 comporte en outre un élément absorbant qui s'échauffe et un élément thermomètre qui mesure cet échauffement, par exemple sous la forme d'un thermistor relié au circuit électronique CMOS par des connexions électriques prévues dans les piliers d'ancrage 12. Par ailleurs, une couche réflectrice 13 repose sur la surface supérieure du substrat 2, située en regard de la membrane absorbante 11. Des portions d'accroche reposent également sur la surface supérieure du substrat 2, par exemple des portions d'accroche 14.1 sur lesquelles la paroi latérale de la couche mince d'encapsulation 21 est destinée à reposer, et des portions d'accroche 14.2 sur lesquels reposent les piliers d'ancrage 12.

En référence à la figure 10B, on dépose une deuxième couche sacrificielle 26.2, préférentiellement de même nature que la première couche sacrificielle, par exemple en polyimide obtenu par dispense et centrifugation. La couche sacrificielle 26.2 recouvre la couche sacrificielle 26.1 ainsi que la membrane absorbante 11 et les piliers d'ancrage 12. Par des techniques classiques de photolithographie, on grave ensuite localement les couches sacrificielles 26.1 et 26.2 jusqu'aux portions d'accroche 14.1. Les zones gravées peuvent prendre la forme de tranchées 27 de périmètre continu et fermé entourant un ou plusieurs détecteurs thermiques 10, ou peuvent prendre la forme d'échancrures localisées entre les détecteurs. On procède ensuite au dépôt conforme d'une première couche mince de haut indice 21, ici de silicium amorphe, qui recouvre à la fois la surface supérieure de la deuxième couche sacrificielle 26.2 et les flancs des tranchées 27, par exemple par un dépôt chimique en phase vapeur (CVD pour *Chemical Vapor Deposition,* en anglais). L'épaisseur de la couche de haut indice 21 en silicium amorphe est environ de 0.73µm pour correspondre à une lame quart d'onde à 10µm. La couche de haut indice est destinée à former la couche mince d'encapsulation 21 de la structure d'encapsulation, et la couche de haut indice 33A du miroir semi-réfléchissant inférieur 32A. Elle s'étend au-dessus et à distance de la membrane absorbante 11, et ici entoure dans le plan (X,Y) de manière continue un ou plusieurs détecteurs thermiques 10.

A cette étape, il est avantageux de déposer puis de graver localement des portions 14.3 d'un matériau basal qui pourra faire office de couche d'arrêt de gravure et/ou de couche d'adhérence aux endroits où il est prévu d'ancrer des éléments de support d'une matrice de filtres interférentiels multispectraux. Le choix de réaliser ou non ces portions de matériau basal, et le cas échéant la nature du matériau basal, est déterminé en fonction des autres matériaux en présence, notamment la nature des couches sacrificielles et des éléments d'ancrage. Dans le cas présent de couches sacrificielles en polyimide et de structures d'ancrage en silicium, les portions basales 14.3 peuvent être réalisées, à titre illustratif, en oxyde de silicium, en nitrure de silicium, en titane, ou en aluminium.

On réalise ensuite une gravure localisée de la couche mince d'encapsulation 21, de manière à réaliser au moins un premier évent de libération 24.1 traversant la couche mince d'encapsulation 21.

En référence, à la figure 10C, on dépose ensuite successivement une troisième couche sacrificielle 26.3, ici en polyimide, qui recouvre la couche mince d'encapsulation 21 et les portions basales 14.3, puis une deuxième couche de haut indice, ici en silicium amorphe, sur la couche sacrificielle 26.3. L'épaisseur de la couche sacrificielle 26.3 est ici de 2.5µm environ pour correspondre avantageusement à une distance optique quart d'onde dans le vide ou l'air, vis-à-vis d'une longueur d'onde de référence ici de 10µm. La deuxième couche de haut indice est destinée à former les portions de haut indice 36 de la couche structurée 35. Son épaisseur optimale est ici de 2µm environ de manière à ne pas introduire de résonances parasites dans la plage de fonctionnement du dispositif de détection multispectrale. La deuxième couche de haut indice peut être déposée par une technique de dépôt CVD qui permet un bon contrôle de l'épaisseur déposée.

Par photolithographie et gravure, on structure ensuite la deuxième couche de silicium amorphe de manière à réaliser une alternance, dans le plan (X,Y), de portions de haut indice 36 en silicium amorphe et de portions de bas indice 37. On peut ainsi former une grille à ouvertures périodiques, par exemple d'un pas P de 2µm. Les dimensions latérales, dans le plan (X,Y), des portions de haut indice 36 sont ajustées pour obtenir une couche structurée 35 d'indice optique moyen prédéfini, et obtenir une réponse spectrale sous forme d'une bande de transmission centrée sur une longueur d'onde centrale déterminée. Dans le cas particulier où la couche structurée 35 est une couche continue sans portions de bas indice 37, on réalise tout de même une gravure localisée de la deuxième couche de silicium amorphe sous la forme de deuxièmes évents de libération qui seront nécessaires pour éliminer les couches sacrificielles 26.1, 26.2, 26.3 sous-jacentes. Un évent de largeur 0.5µm répété à un pas de 20µm, jusqu'à 50µm, peut convenir sans perturber significativement la réponse spectrale du filtre.

A ce stade, dans le cadre d'une détection multispectrale du dispositif de détection, on prévoit que la couche structurée 35 présente des dimensions latérales des portions 36 et 37 différentes pour plusieurs détecteurs thermiques, ce qui permet de doter les détecteurs élémentaires d'une sélectivité fréquentielle prédéfinie par les dimensions latérales de la couche structurée pour chaque filtre interférentiel. Il est également possible de prévoir une couche structurée dont les motifs formés par les portions 36 et 37 sont agencées de manière apériodique au-dessus d'un même détecteur élémentaire, de manière à élargir la réponse spectrale du filtre interférentiel et donc du détecteur thermique en question.

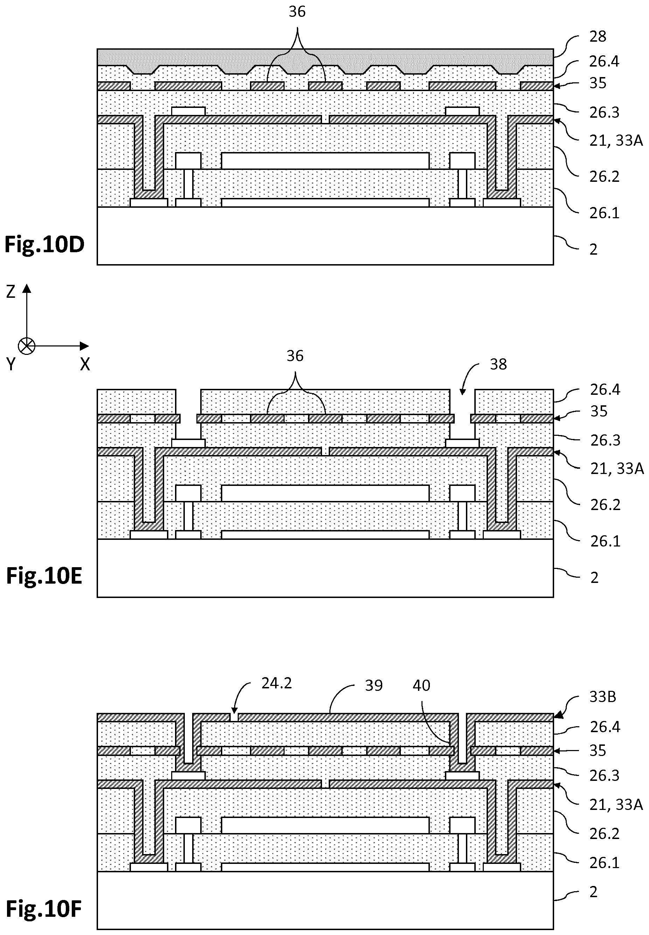

En référence à la figure 10D, on dépose ensuite une première épaisseur d'une quatrième couche sacrificielle 26.4, ici en polyimide, d'épaisseur de préférence supérieure à 2µm, par exemple 3µm. Puis on dépose une couche planarisante 28, par exemple une résine photosensible adaptée, par dispense et centrifugation. L'épaisseur de la couche planarisante 28, et la fluidité de la résine, sont choisies de manière à combler après centrifugation les reliefs résiduels de la face supérieure de la couche sacrificielle 26.4. Une étape chimique de gravure sèche, par exemple par plasma d'oxygène, permet ensuite de graver dans le même temps la couche planarisante 28 et la couche sacrificielle 26.4, avec une vitesse de gravure sensiblement identique pour les deux matériaux, se traduisant par un front de gravure essentiellement plan. L'étape de gravure est stoppée au moment où le front de gravure découvre la face supérieure des portions de haut indice 36 de la couche structurée 35. Cet instant peut être détecté automatiquement par un dispositif de détection de fin d'attaque, par exemple par une analyse spectroscopique d'émission optique. A ce stade, on obtient une couche structurée 35 dont les portions de haut indice 36 présentent chacune une surface supérieure sensiblement non recouverte par un autre matériau, et dont les interstices dans le plan (X,Y) sont remplis par la couche sacrificielle 26.4.

Un résultat similaire peut être obtenu par un procédé de polissage mécano-chimique (CMP) mais qui doit être adapté à la nature organique des couches sacrificielles, ici en polyimide. Dans le cas où on utiliserait des couches sacrificielles minérales, par exemple en oxyde de silicium comme décrit plus loin en lien avec un quatrième mode de réalisation, un procédé CMP serait particulièrement avantageux.

En référence à la figure 10E, on dépose ensuite une deuxième épaisseur de la quatrième couche sacrificielle 26.4, ici en polyimide, d'épaisseur 2.5µm environ. Par photolithographie et gravure, on réalise ensuite des tranchées 38, continues périphériques, ou localisées et non continues, par gravure successive de la couche sacrificielle 26.4, de la couche structurée 35 au niveau d'une portion de haut indice 36, ainsi que de la couche sacrificielle 26.3, jusqu'aux portions basales 14.3 qui font avantageusement office de couche d'arrêt de gravure. La séquence de gravure prévoit avantageusement une étape de gravure isotrope des couches sacrificielles 26.3 et 26.4 en polyimide, de manière à dégager des parties de portions de haut indice 36, en saillie dans la tranchée 38. Ces parties en saillie faciliteront le maintien mécanique de la couche structurée 35 avec des parois de support 40 du dispositif de filtrage optique.

En référence à la figure 10F, on dépose une troisième couche de haut indice, ici en silicium amorphe, dont l'épaisseur est de 0.73µm environ pour correspondre à une lame quart d'onde à la longueur d'onde de référence de 10µm. Le dépôt conforme, par exemple de type CVD, est particulièrement avantageux dans la mesure où il permet à la troisième couche de haut indice de recouvrir le flanc des tranchées 38. Le bon recouvrement des flancs de gravure permet de réaliser dans une même couche de haut indice, à la fois une paroi supérieure 39 de la couche de haut indice 33B du miroir semi-réfléchissant supérieur 32B, et une paroi latérale 40, éventuellement périphérique, de support du dispositif de filtrage optique sur la structure d'encapsulation. Avantageusement, la paroi latérale 40 est au contact des parties en saillie des portions de haut indice 36 débouchant dans les tranchées 38, ce qui permet de solidariser solidement la couche structurée 35 à la structure de filtrage optique. Une étape de gravure permet de réaliser des évents de libération 24.2 à travers la paroi supérieure 39 de la couche de haut indice 33B.

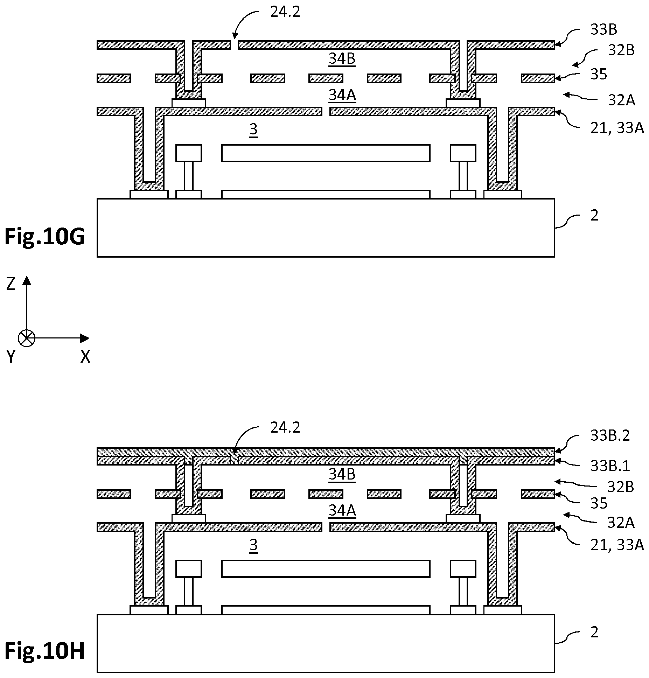

En référence à la figure 10G, on réalise l'élimination des différentes couches sacrificielles 26.1, 26.2, 26.3, 26.4, par exemple par gravure sèche, sous plasma d'oxygène, avec apport éventuel de N2 et de CF4, à travers les différents d'évents de libération 24.1 et 24.2 et à travers les interstices des portions de haut indice 36 qui formeront les portions de bas indice 37, de manière à mettre en suspension la membrane absorbante 11 du détecteur thermique, et de manière à obtenir les couches de bas indice 34A, 34B des miroirs inférieur 32A et supérieur 32B, et les portions de bas indice 37 de la couche structurée 35. On obtient ainsi un filtre interférentiel à fort saut d'indice comportant une couche structurée 35 suspendue entre les deux miroirs semi-réfléchissants 32A, 32B.

Selon une variante, le dispositif de détection ainsi obtenu est ensuite intégré dans une cavité hermétique sous vide ou sous pression réduite, par exemple dans un boîtier hermétique à l'intérieur duquel est placé le substrat 2 du dispositif. La mise sous vide au niveau du boîtier se répercute via les évents 24.1 et 24.2, de manière à obtenir à la fois des détecteurs thermiques avec des membranes thermiquement isolées par le vide, et des filtres interférentiels à fort saut d'indice utilisant le silicium amorphe comme matériau de haut indice (n=3.5) et le vide comme milieu de bas indice (n=1).

Selon une autre variante illustrée sur la figure 10H, à la suite de l'étape d'élimination des couches sacrificielles 26.1, 26.2, 26.3, 26.4, on réalise la mise sous vide du dispositif de détection, et on dépose une couche de scellement 33B.2 sur la couche en silicium amorphe 33B.1 du miroir supérieur 32B, de manière à obturer l'évent de libération 24.2. La cavité 3 est alors sous vide et est rendue hermétique par la couche de scellement 33B.2. La couche de scellement 33B.2 est réalisée en un matériau de haut indice, par exemple du germanium, c'est-à-dire que son indice de réfraction est supérieur à celui du milieu des couches de bas indice 34A, 34B, et du milieu des portions de bas indice 37. Son épaisseur, par exemple ici 1,2µm, est ajustée de telle sorte que l'empilement de la sous-couche 33B.1 de silicium amorphe et de la sous-couche 33B.2 de germanium forme une lame trois quart d'onde pour une longueur d'onde de référence de 10µm.

Selon une autre variante (non représentée), à la suite de l'étape d'élimination des couches sacrificielles 26.1, 26.2, 26.3, 26.4, on réalise la mise sous vide du dispositif de détection, et on dépose un plot d'un matériau de scellement au niveau de l'évent 24.2, de manière à obtenir l'herméticité de la cavité 3 sous vide. La couche de haut indice 33B du miroir semi-réfléchissant supérieur 32B ne comporte alors que la couche de silicium amorphe.

Ainsi, par le fait que les couches sacrificielles 26.1, 26.2, 26.3 et 26.4 sont réalisées en un même matériau, ici le polyimide, et par la présence des évents de libération 24.1 et 24.2 et des interstices entre les portions de haut indice 36, il est possible d'éliminer les différentes couches sacrificielles en une seule étape, et donc d'obtenir dans le même temps la suspension de la membrane suspendue 11 et celle de la couche structurée 35. Le procédé de réalisation est donc fortement simplifié.

Ceci est en outre accentué par le fait que les miroirs semi-réfléchissants ne comportent chacun qu'une seule couche de haut indice, et avantageusement une couche de bas indice située entre la couche de haut indice et la couche structurée, et non pas une superposition de plusieurs couches de haut indice séparées les unes des autres par des couches de bas indice comme dans le cas classique des miroirs diélectriques multicouches.

Le procédé permet ainsi d'obtenir une libération simple et rapide de la couche structurée et la formation d'au moins une couche de bas indice, sans que cela n'affecte la qualité de réponse spectrale du filtre, en termes de sélectivité de transmission et de qualité de réjection.

Ainsi, la ou les couches de bas indice des miroirs semi-réfléchissants peuvent être obtenues avec un procédé de libération de couche sacrificielle comme pour la réalisation du micro-bolomètre. Le fait d'avoir restreint l'empilement de chacun des miroirs à une seule couche de haut indice limite à seulement deux le nombre de couches sacrificielles de la cavité Fabry-Pérot, ce qui permet d'effectuer une libération de ces deux couches en une seule étape. Le procédé de réalisation de la matrice de filtres est ainsi particulièrement simple, avec peu de couches à déposer, une seule étape de libération, et une seule étape de structuration. Il est surprenant de pouvoir obtenir avec cette architecture simplifiée de filtre interférentiel et un procédé de réalisation simple et compatible avec celui du micro-bolomètre, des réponses spectrales qui restent sélectives en termes de finesse des pics de transmission, et en termes de réjection.

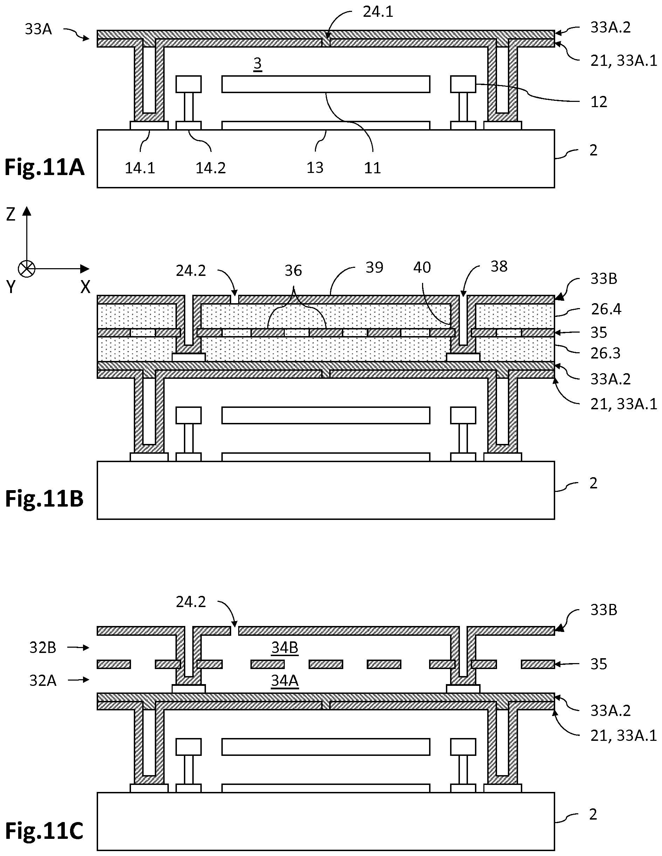

Les figures 11A à 11C illustrent différentes étapes d'un procédé de réalisation du dispositif selon un quatrième mode de réalisation. Dans cet exemple, seul le miroir inférieur 32A comporte une sous-couche de scellement 33A.2 rendant hermétique la cavité 3.

En référence à la figure 11A, on réalise une matrice de détecteurs thermiques sur un substrat 2 comportant un circuit électronique CMOS, une structure d'encapsulation formant avec le substrat 2 une cavité hermétique 3 dans laquelle sont situés un ou plusieurs détecteurs thermiques. Ici, une couche de scellement 33A.2 est déposée sur une couche mince d'encapsulation 21 avec une épaisseur suffisante pour assurer le scellement, c'est-à-dire l'obturation, de l'évent de libération 24.1. La couche mince d'encapsulation 21 forme en outre une sous-couche 33A.1 de la couche de haut indice 33A du miroir semi-réfléchissant inférieur 32A, alors que la couche de scellement 33A.2 forme une deuxième sous-couche de la couche de haut indice 33A. La couche mince d'encapsulation 21 peut être réalisée par une première couche en silicium amorphe, par exemple d'épaisseur 0.73µm. La couche de scellement 33A.2 est également transparente au rayonnement infrarouge, et peut être formée par exemple d'une couche de germanium, de préférence déposée par une technique de dépôt de couches minces sous vide, comme l'évaporation sous vide d'une source chauffée par faisceau d'électrons (EBPVD, pour *Electron Beam Physical Vapor Deposition,* en anglais). On obtient ainsi une cavité hermétique 3 sous vide ou pression réduite dans laquelle est logée la matrice de détecteurs. Comme le décrit la demande de brevet FR1551487, la largeur moyenne X transversale de l'évent 24.1 peut être choisie en fonction de l'épaisseur e de la couche de scellement déposée, de la fraction de l'épaisseur B de la couche de scellement 33A.2 assurant effectivement l'herméticité, et de l'angle de croissance α de la couche de scellement 33A.2, à partir de la relation : X = 2.e.(1-B).tan(α). A titre d'exemple, pour une technique de dépôt de la couche de scellement 33A.2 par évaporation, l'angle α est typiquement de l'ordre de 15° à 20°.

Pour une épaisseur de la couche mince d'encapsulation 21 en silicium amorphe de 0.73µm, il est avantageux de prévoir une couche de scellement 33A.2 en germanium de 1.25µm de manière à obtenir une couche de haut indice 33A formant une lame trois quart d'onde pour une longueur d'onde de référence de 10µm, ce qui permet d'obtenir un filtre interférentiel avec un seul pic de transmission dans le domaine spectral de détection 8-14µm. Si l'on souhaite que deux tiers de la couche de scellement, soit 0.83µm de germanium, assure l'herméticité de la cavité 3, on obtient une largeur moyenne transversale X de l'évent comprise de préférence entre 0.22µm et 0.3µm.

En référence à la figure 11B, on réalise la couche structurée 35 et la couche de haut indice 33B sur les couches sacrificielles 26.3 et 26.4 par les étapes décrites précédemment, à ceci près qu'elles sont effectuées sur une cavité hermétique 3 sous vide ou sous pression réduite, dans laquelle sont logés un ou plusieurs détecteurs thermiques. On obtient ainsi une matrice de détecteurs logés seuls ou à plusieurs dans une ou plusieurs cavités hermétiques 3 formées par une structure d'encapsulation, sur laquelle repose une structure de filtrage optique comportant une matrice de filtres disposés chacun en regard d'un détecteur thermique. La cavité hermétique 3 est libre de toute couche sacrificielle alors que les filtres comportent les couches sacrificielles 26.3 et 26.4 entre les couches de haut indice 33A.1 et 33A.2, et 33B, et au niveau de la couche structurée 35.

En référence à la figure 11C, on réalise ensuite l'élimination des troisième et quatrième couches sacrificielles 26.3, 26.4 à travers l'évent de libération 24.2 et les interstices des portions de haut indice 36, de manière à former un filtre interférentiel à fort saut d'indice comportant une couche structurée 35 à portions de haut indice 36 en silicium amorphe et à portions de bas indice d'air, suspendue entre les couches de haut indice 33A.1 et 33A.2, et 33A des miroirs semi-réfléchissants 32A, 32B, chacun comportant en outre une couche de bas indice d'air 34A, 34B séparant la couche de haut indice correspondante de la couche structurée. Dans ce mode de réalisation, les troisième et quatrième couches sacrificielles 26.3, 26.4 sont éliminées à une étape différente de celle où on élimine les première et deuxième couches sacrificielles 26.1, 26.2. Il en résulte que ces deux paires de couches sacrificielles peuvent être prévues dans des matériaux différents, les troisième et quatrième couches sacrificielles 26.3, 26.4 pouvant, par exemple, être en oxyde de silicium, qui peut être éliminé par gravure chimique en milieu HF vapeur. L'utilisation d'oxyde de silicium à la place du polyimide peut simplifier l'étape de planarisation de la première épaisseur de la quatrième couche sacrificielle 26.4 en ayant préférentiellement recours à une technique de CMP. La couche basale 14.3 pourra être par exemple en aluminium, de manière à résister à l'attaque HF en phase vapeur.

En variante non représentée, il peut ensuite être avantageux d'obturer l'évent 24.2 par le dépôt d'une couche mince transparente au rayonnement infrarouge, par exemple une couche de germanium ou une couche de silicium amorphe. Cette sous-couche additionnelle de scellement peut être prévue pour réaliser conjointement avec la sous-couche de silicium amorphe une lame trois quart d'onde pour la longueur d'onde de référence de 10µm, ce qui permet d'obtenir un filtre interférentiel avec un seul pic de transmission dans le domaine spectral de détection 8-14µm. Pour cela, on peut déposer une couche de scellement en silicium amorphe de 1.5µm ou une couche de germanium de 1.25µm, sur la couche 33B de silicium amorphe de 0.73µm. L'intérêt d'obturer l'évent 24.2 est d'éviter que des agents extérieurs, susceptibles de dégrader la tenue mécanique des filtres, ne pénètrent à l'intérieur des filtres interférentiels. Il n'est pas nécessaire que cette couche additionnelle de scellement ait la fonction de maintenir sous vide les cavités des filtres interférentiels, de sorte que les techniques de dépôt sous pression intermédiaire (pulvérisation cathodique, CVD par exemple) peuvent être utilisées et apporter l'avantage d'une durée de dépôt inférieur, ce qui contribue à diminuer le coût de production du dispositif de détection. Avantageusement, on peut déposer une couche anti-reflet (par exemple une couche quart d'onde en ZnS, ou une couche texturée en Si) au sommet de l'empilement pour améliorer la réjection aux deux extrémités du domaine spectral de détection 8-14µm.

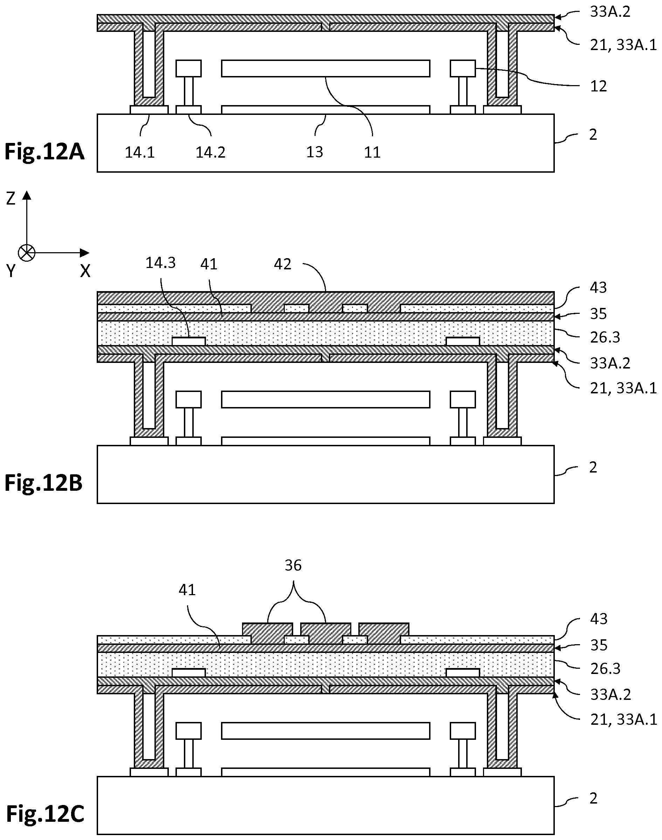

Les figures 12A à 12E illustrent différentes étapes d'un procédé de réalisation du dispositif selon un cinquième mode de réalisation. Dans cet exemple, le miroir semi-réfléchissant inférieur 32A comporte une sous-couche de scellement 33A.2, et la couche structurée 35 comporte une couche continue de haut indice 41 sur laquelle repose une alternance de portions de haut indice 36 et de portions de bas indice 37.

La figure 12A est identique ou similaire à la figure 11A et n'est donc pas décrite en détail. Une matrice de détecteurs thermiques 10 repose sur le substrat 2 et une structure d'encapsulation, formée d'une couche mince d'encapsulation 21 et ici d'une couche de scellement 33A.2, délimite avec le substrat 2 une ou plusieurs cavités hermétiques 3 logeant chacune un ou plusieurs détecteurs thermiques 10.

En référence à la figure 12B, on réalise ensuite des portions basales 14.3, identiques ou similaires à celles décrites précédemment, ces portions basales étant facultatives, et on dépose une troisième couche sacrificielle 26.3 par exemple en oxyde de silicium de manière à recouvrir les portions basales 14.3 et la couche de scellement 33A.2. A ce titre, les troisièmes et quatrièmes couches sacrificielles 26.3 et 26.4 sont ici en oxyde de silicium mais du polyimide pourrait être utilisé.

On dépose ensuite une couche 41 de haut indice, ici en silicium amorphe, par exemple de 0.73µm d'épaisseur, de manière à recouvrir la couche sacrificielle 26.3, puis une fine couche d'arrêt de gravure 43, choisie préférentiellement en oxyde de silicium de manière à pouvoir être éliminée avec les couches sacrificielles 26.3 et 26.4, dans une gamme d'épaisseur comprise entre 10nm et 200nm, par exemple entre 30nm et 50nm. Par des procédés de photolithographie et de gravure de la couche d'arrêt 43, on réalise ici des ouvertures sous la forme de trous débouchant sur la couche sous-jacente 41. Dans une variante non représentée, on peut graver la couche d'arrêt 43 pour ne garder que des plots disposés sur la couche 41. On dépose ensuite une couche 42 de haut indice, ici en silicium amorphe, par exemple de 1.36µm d'épaisseur. De préférence, la couche de haut indice 41 présente une épaisseur inférieure à environ 60% de l'épaisseur totale des couches 41 et 42, pour limiter les résonances parasites dans la plage de fonctionnement du dispositif de détection multispectrale.

En référence à la figure 12C, on réalise ensuite, par des procédés de photolithographie et de gravure de la couche de haut indice 42 un réseau de portions de haut indice 36. Chaque portion 36 présente ainsi une épaisseur sensiblement égale à l'épaisseur de la couche 42 initiale, et est en contact avec la couche continue sous-jacente de haut indice 41.

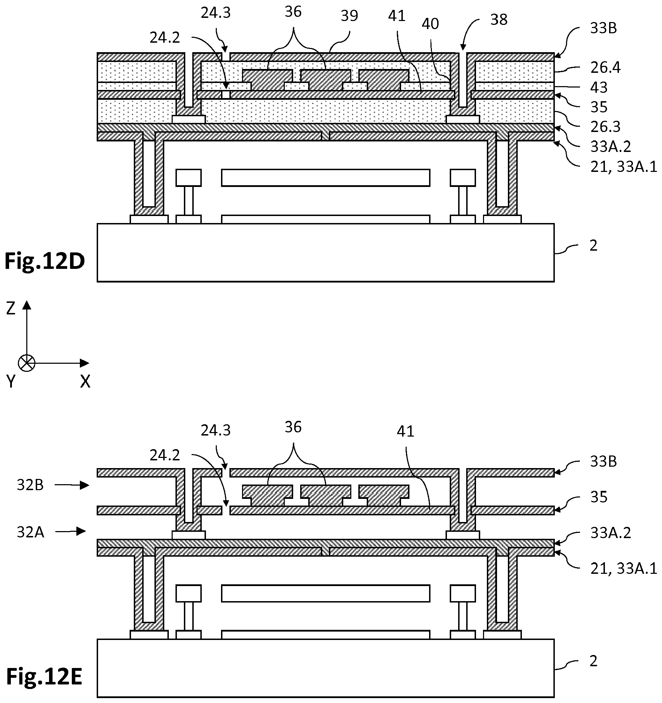

En référence aux figures 12D et 12E, on effectue les étapes déjà décrites précédemment, mais qui, dans le cas présent, prévoit d'éliminer la couche d'arrêt de gravure 43 en même temps que l'on élimine les couches sacrificielles 26.3 et 26.4 en oxyde de silicium. L'élimination de ces couches 26.3, 43 et 26.4 en oxyde de silicium est réalisée par une attaque acide par HF vapeur, à travers des deuxièmes et troisièmes évents 24.2 et 24.3, prévus respectivement au niveau de la couche continue 41 de la couche structurée 35 et au niveau de la couche de haut indice 33B du miroir supérieur 32B. On obtient ainsi un filtre interférentiel dont la couche structurée comporte une couche continue de haut indice 41 sur laquelle reposent les portions de haut indice 36. La couche continue 41 est au contact de la paroi latérale 40 de manière à assurer la tenue mécanique de la couche structurée 35.

Dans ce mode de réalisation, l'ouverture du deuxième évent 24.2 est possible à plusieurs stades, soit après le dépôt de la couche continue 41, soit entre la gravure de la couche 42 et le dépôt de la couche sacrificielle 26.4 (selon cette deuxième option, on grave un ensemble de 2 couches, séquentiellement en oxyde de silicium et en silicium amorphe), avec un niveau de masque et une étape de gravure dédiés à la réalisation des deuxièmes évents, soit en même temps que la réalisation du troisième évent 24.3. D'autres approches sont possibles. De manière facultative, on peut ensuite procéder, tel que décrit précédemment, à l'obturation des troisièmes évents 24.3 par le dépôt d'une couche mince de scellement transparente au rayonnement infrarouge, par exemple en germanium, voire d'une couche antireflet en ZnS.

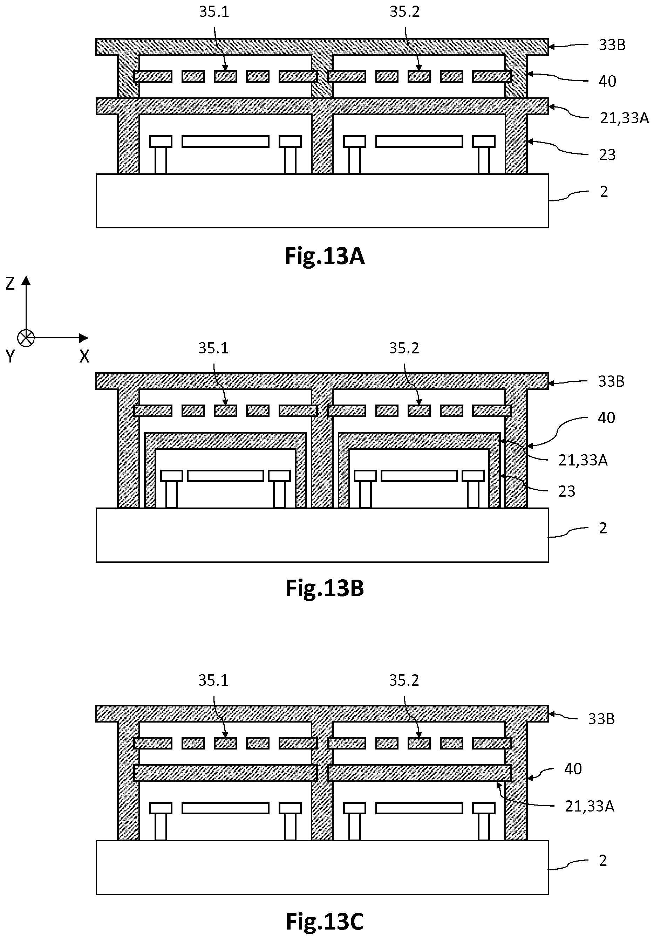

Les figures 13A à 13C illustrent différentes variantes du dispositif de détection de rayonnement électromagnétique, qui se distinguent les unes des autres essentiellement par la manière dont la structure de filtrage optique repose sur le substrat 2.

La figure 13A montre une vue schématique en coupe dans laquelle des éléments de support 40 d'une matrice de filtres interférentiels multispectraux reposent sur la face supérieure de la structure d'encapsulation, tel que décrit jusqu'à présent.

La figure 13B montre une vue schématique en coupe dans laquelle les parois de support 40 d'une matrice de filtres interférentiels multispectraux reposent sur la face supérieure du substrat 2. La structure d'encapsulation n'assure donc pas le maintien mécanique de la structure de filtrage optique.

La figure 13C montre une vue schématique en coupe dans laquelle les parois de support 40 reposent sur la face supérieure du substrat 2 et soutiennent à la fois une matrice de filtres interférentiels multispectraux et la couche mince d'encapsulation des détecteurs thermiques.

Des modes de réalisation particuliers viennent d'être décrits. Différentes variantes et modifications apparaîtront à l'homme du métier. En particulier, il est possible que la structure de filtrage optique comporte une pluralité de filtres interférentiels par détecteur thermique, les filtres étant alors superposés les uns aux autres suivant l'axe Z.

## Revendications

1. Dispositif de détection (1) de rayonnement électromagnétique, comportant :
- un substrat (2) ;
- au moins un détecteur thermique (10), disposé sur le substrat ;
- une structure d'encapsulation (20) agencée de manière à définir avec le substrat une cavité (3) logeant ledit détecteur thermique, comportant au moins une couche mince d'encapsulation (21) s'étendant au-dessus du détecteur thermique ;
**caractérisé en ce qu'**il comporte en outre :
- au moins un filtre interférentiel (31) à cavité Fabry-Pérot, disposé au niveau de la structure d'encapsulation et à distance du détecteur thermique, formé par des premier et deuxième miroirs semi-réfléchissants (32A, 32B) espacés l'un de l'autre par une couche dite structurée (35) ;
∘ chaque miroir semi-réfléchissant (32A, 32B) comportant une couche dite de haut indice de réfraction (33A, 33B) réalisée en au moins un matériau diélectrique ou semiconducteur, laquelle présentant une épaisseur égale à un multiple du rapport d'une longueur d'onde de référence comprise dans un domaine spectral de détection du détecteur thermique (10) sur quatre fois son indice de réfraction ;
∘ la couche structurée (35) comportant une alternance, dans un plan parallèle au plan du substrat, de portions (36) dites de haut indice de réfraction réalisées en au moins un matériau diélectrique ou semiconducteur, et de portions (37) dites de bas indice de réfraction réalisées en un milieu dont l'indice de réfraction est inférieur à celui du matériau des portions de haut indice ;
∘ la couche de haut indice (33A) de l'un desdits miroirs semi-réfléchissants (32A) étant au moins en partie formée de ladite couche mince d'encapsulation (21).

2. Dispositif de détection (1) selon la revendication 1, dans lequel chaque miroir semi-réfléchissant (32A, 32B) comporte une unique couche de haut indice (33A, 33B), et au moins l'un desdits miroirs semi-réfléchissants comporte une couche dite de bas indice (34A, 34B) réalisée en un milieu dont l'indice de réfraction est inférieur à celui du matériau de la couche de haut indice (33A, 33B), ladite couche de bas indice (34A, 34B) étant située entre la couche de haut indice (33A, 33B) et la couche structurée (35).

3. Dispositif de détection (1) selon la revendication 2, dans lequel la différence entre l'indice de réfraction du matériau de la couche de haut indice (33A, 33B) et celui du milieu de la couche de bas indice (34A, 34B) est supérieure ou égale à 1,5.

4. Dispositif de détection (1) selon la revendication 2 ou 3, dans lequel le milieu de la couche de bas indice (34A, 34B) et des portions de bas indice (37) est du vide ou un gaz.

5. Dispositif de détection (1) selon l'une quelconque des revendications 1 à 4, dans lequel la couche de haut indice (33A, 33B) d'au moins l'un desdits miroirs semi-réfléchissants est formée d'un empilement d'au moins deux sous-couches (33A.1, 33A.2 ; 33A.1, 33A.2) en contact l'une de l'autre et réalisées en des matériaux différents.

6. Dispositif de détection (1) selon l'une quelconque des revendications 1 à 5, dans lequel la couche structurée (35) présente une proportion volumique de portions de haut indice (36) supérieure ou égale à 30%.

7. Dispositif de détection (1) selon l'une quelconque des revendications 1 à 6, dans lequel la couche structurée (35) comporte une couche continue (41) sur laquelle reposent les portions de haut indice (36).

8. Dispositif de détection (1) selon l'une quelconque des revendications 1 à 7, dans lequel la couche de haut indice (33B) d'un miroir semi-réfléchissant dit supérieur (32B) comporte une paroi dite supérieure (39) située en regard de la couche structurée (35), et des parois dites latérales (40) situées de part et d'autre de la paroi supérieure (39), la couche structurée (35) étant maintenue au-dessus de la couche de haut indice (33A) d'un miroir semi-réfléchissant dit inférieur (32A) par les parois latérales (40).

9. Dispositif de détection (1) selon l'une quelconque des revendications 1 à 8, dans lequel la couche mince d'encapsulation (21) s'étend continûment autour du détecteur thermique (10) de manière à former une paroi supérieure (22) située au-dessus du détecteur thermique (10) et une paroi latérale (23) reposant sur le substrat (2).

10. Dispositif de détection (1) selon l'une quelconque des revendications 1 à 9, comportant :
- une pluralité de détecteurs thermiques (10) disposés sur le substrat (2), au-dessus desquels s'étend ladite couche mince d'encapsulation (21) ;
- une pluralité de filtres interférentiels (31) à cavité Fabry-Pérot, disposés chacun au niveau de la structure d'encapsulation (30) ;
- la couche mince d'encapsulation (21) étant commune à plusieurs couches de haut indice (33A) de l'un desdits miroirs semi-réfléchissants (32A) des différents filtres interférentiels (31).

11. Dispositif de détection (1) selon la revendication 10, dans lequel les miroirs semi-réfléchissants (32A, 32B) et les couches structurées (35) des filtres interférentiels (31) sont respectivement coplanaires d'un filtre interférentiel à l'autre.

12. Procédé de réalisation d'un dispositif de détection (1) selon l'une quelconque des revendications 1 à 11, comportant au moins les étapes suivantes :
a. réalisation d'au moins un détecteur thermique (10) ;
b. réalisation d'une structure d'encapsulation (20) agencée de manière à définir avec le substrat (2) une cavité (3) logeant ledit détecteur thermique, comportant au moins une couche mince d'encapsulation (21) s'étendant au-dessus du détecteur thermique et reposant sur une couche sacrificielle (26.2) recouvrant ledit détecteur thermique ;
c. réalisation d'au moins un filtre interférentiel (31) à cavité Fabry-Pérot, une couche sacrificielle (26.4) étant située entre les portions de haut indice (36) de la couche structurée (35), et éventuellement entre une couche de haut indice (33A, 33B) et la couche structurée (35) ;
d. élimination desdites couches sacrificielles (26.2, 26.4).

13. Procédé de réalisation selon la revendication 12, dans lequel l'élimination des couches sacrificielles (26.2, 26.4) est effectuée en une même étape, ultérieurement à l'étape de réalisation du filtre interférentiel (31), les couches sacrificielles (26.2, 26.4) étant réalisées en un même matériau, les couches de haut indice (33A, 33B) des deux miroirs semi-réfléchissants (32A, 32B) comportant chacune un orifice traversant (24.1, 24.3), et les portions de bas indice (37) de la couche structurée (35) étant traversants.

14. Procédé de réalisation selon la revendication 12, dans lequel l'élimination des couches sacrificielles est réalisée en deux sous-étapes :
- une première sous-étape d'élimination de la couche sacrificielle (26.2) sur laquelle repose la couche mince d'encapsulation (21), effectuée antérieurement à l'étape de réalisation du filtre interférentiel (31), la couche mince d'encapsulation (21) comportant un orifice traversant (24.1) et une couche de scellement (33A.2) étant ensuite déposée sur la couche mince d'encapsulation (21) de manière à obturer l'orifice traversant (24.1) ; et
- une deuxième sous-étape d'élimination de la couche sacrificielle (26.4) située entre les portions de haut indice (36) de la couche structurée (35), la couche de haut indice (33B) du miroir semi-réfléchissant supérieur (32B) comportant un orifice traversant (24.3).

## Patentansprüche

1. Vorrichtung zur Detektion (1) von elektromagnetischer Strahlung, umfassend:
- ein Substrat (2);
- mindestens einen auf dem Substrat angeordneten Thermodetektor (10);
- eine Einkapselungsstruktur (20), die so gestaltet ist, dass sie mit dem Substrat eine den Thermodetektor aufnehmende Kavität (3) definiert, umfassend mindestens eine dünne Einkapselungsschicht (21), die sich über dem Thermodetektor erstreckt;
**dadurch gekennzeichnet, dass** sie ferner umfasst:
- mindestens ein auf Höhe der Einkapselungsstruktur und mit Abstand zum Thermodetektor angeordnetes Interferenzfilter (31) mit Fabry-Perot-Kavität, das durch erste und zweite halbreflektierende Spiegel (32A, 32B) gebildet wird, die voneinander durch eine sogenannte strukturierte Schicht (35) beabstandet sind;
∘ wobei jeder halbreflektierende Spiegel (32A, 32B) eine sogenannte Hochbrechungsindexschicht (33A, 33B) umfasst, die aus mindestens einem dielektrischen oder Halbleitermaterial ausgeführt ist, die eine Dicke aufweist, die gleich einem Vielfachen des Verhältnisses einer im Detektionsspektralbereich des Thermodetektors (10) enthaltenen Referenzwellenlänge zum Vierfachen ihres Brechungsindexes ist;
∘ wobei die strukturierte Schicht (35) in einer parallel zur Ebene des Substrats verlaufenden Ebene eine Wechselfolge von sogenannten Hochbrechungsindexabschnitten (36) aus mindestens einem dielektrischen oder Halbleitermaterial und sogenannten Niedrigbrechungsindexabschnitten (37) aus einem Milieu, dessen Brechungsindex geringer als der des Materials der Hochindexabschnitte ist, umfasst;
∘ wobei die Hochindexschicht (33A) des einen der halbreflektierenden Spiegel (32A) zumindest teilweise aus der dünnen Einkapselungsschicht (21) gebildet wird.

2. Detektionsvorrichtung (1) nach Anspruch 1, bei der jeder halbreflektierende Spiegel (32A, 32B) eine einzige Hochindexschicht (33A, 33B) umfasst und mindestens einer der halbreflektierenden Spiegel eine sogenannte Niedrigindexschicht (34A, 34B) umfasst, die aus einem Milieu ausgeführt ist, dessen Brechungsindex geringer als der des Materials der Hochindexschicht (33A, 33B) ist, wobei die Niedrigindexschicht (34A, 34B) zwischen der Hochindexschicht (33A, 33B) und der strukturierten Schicht (35) gelegen ist.

3. Detektionsvorrichtung (1) nach Anspruch 2, bei der die Differenz zwischen dem Brechungsindex des Materials der Hochindexschicht (33A, 33B) und dem des Milieus der Niedrigindexschicht (34A, 34B) größer als oder gleich 1,5 ist.

4. Detektionsvorrichtung (1) nach Anspruch 2 oder 3, bei der das Milieu der Niedrigindexschicht (34A, 34B) und der Niedrigindexabschnitte (37) Vakuum oder ein Gas ist.

5. Detektionsvorrichtung (1) nach einem der Ansprüche 1 bis 4, bei der die Hochindexschicht (33A, 33B) mindestens eines der halbreflektierenden Spiegel aus einem Schichtsystem aus mindestens zwei Teilschichten (33A.1, 33A.2; 33A.1, 33A.2) gebildet wird, die einander kontaktieren und aus verschiedenen Materialien ausgeführt sind.

6. Detektionsvorrichtung (1) nach einem der Ansprüche 1 bis 5, bei der die strukturierte Schicht (35) ein Volumenverhältnis von Hochindexabschnitten (36) größer als oder gleich 30 % aufweist.

7. Detektionsvorrichtung (1) nach einem der Ansprüche 1 bis 6, bei der die strukturierte Schicht (35) eine durchgehende Schicht (41) umfasst, auf der die Hochindexabschnitte (36) ruhen.

8. Detektionsvorrichtung (1) nach einem der Ansprüche 1 bis 7, bei der die Hochindexschicht (33B) eines sogenannten oberen halbreflektierenden Spiegels (32B) eine sogenannte obere Wand (39) umfasst, die gegenüber der strukturierten Schicht (35) gelegen ist, und sogenannte seitliche Wände (40), die beidseits der oberen Wand (39) gelegen sind, wobei die strukturierte Schicht (35) von den seitlichen Wänden (40) über der Hochindexschicht (33A) eines sogenannten unteren halbreflektierenden Spiegels (32A) gehalten wird.

9. Detektionsvorrichtung (1) nach einem der Ansprüche 1 bis 8, bei der sich die dünne Einkapselungsschicht (21) durchgehend um den Thermodetektor (10) herum erstreckt, so dass eine obere Wand (22), die über dem Thermodetektor (10) gelegen ist, und eine seitliche Wand (23), die auf dem Substrat (2) ruht, gebildet werden.

10. Detektionsvorrichtung (1) nach einem der Ansprüche 1 bis 9, umfassend:
- eine Vielzahl von Thermodetektoren (10), die auf dem Substrat (2) angeordnet sind, über denen sich die dünne Einkapselungsschicht (21) erstreckt;
- eine Vielzahl von Interferenzfiltern (31) mit Fabry-Perot-Kavität, die jeweils auf Höhe der Einkapselungsstruktur (30) angeordnet sind;
- wobei die dünne Einkapselungsschicht (21) mehreren Hochindexschichten (33A) des einen der halbreflektierenden Spiegel (32A) der verschiedenen Interferenzfilter (31) gemein ist.

11. Detektionsvorrichtung (1) nach Anspruch 10, bei der die halbreflektierenden Spiegel (32A, 32B) und die strukturierten Schichten (35) der Interferenzfilter (31) jeweils von einem Interferenzfilter zum anderen komplanar sind.

12. Verfahren zur Ausführung einer Detektionsvorrichtung (1) nach einem der Ansprüche 1 bis 11, umfassend mindestens die folgenden Schritte:
a. Ausführen mindestens eines Thermodetektors (10);
b. Ausführen einer Einkapselungsstruktur (20), die so gestaltet ist, dass sie mit dem Substrat (2) eine den Thermodetektor aufnehmende Kavität (3) definiert, umfassend mindestens eine dünne Einkapselungsschicht (21), die sich über dem Thermodetektor erstreckt und auf einer den Thermodetektor bedeckenden Opferschicht (26.2) ruht;
c. Ausführen mindestens eines Interferenzfilters (31) mit Fabry-Perot-Kavität, wobei eine Opferschicht (26.4) zwischen den Hochindexabschnitten (36) der strukturierten Schicht (35) und gegebenenfalls zwischen einer Hochindexschicht (33A, 33B) und der strukturierten Schicht (35) gelegen ist;
d. Eliminierung der Opferschichten (26.2, 26.4).

13. Ausführungsverfahren nach Anspruch 12, bei dem die Eliminierung der Opferschichten (26.2, 26.4) in demselben Schritt nach dem Schritt des Ausführens des Interferenzfilters (31) erfolgt, wobei die Opferschichten (26.2, 26.4) aus demselben Material ausgeführt sind, wobei die Hochindexschichten (33A, 33B) der beiden halbreflektierenden Spiegel (32A, 32B) jeweils eine Durchgangsöffnung (24.1, 24.3) umfassen und die Niedrigindexabschnitte (37) der strukturierten Schicht (35) durchgehend sind.

14. Ausführungsverfahren nach Anspruch 12, bei dem die Eliminierung der Opferschichten in zwei Teilschritten ausgeführt wird:
- einem ersten Teilschritt des Eliminierens der Opferschicht (26.2), auf der die dünne Einkapselungsschicht (21) ruht, der vor dem Schritt des Ausführens des Interferenzfilters (31) durchgeführt wird, wobei die dünne Einkapselungsschicht (21) eine Durchgangsöffnung (24.1) umfasst, und anschließend eine Versiegelungsschicht (33A.2) auf die dünne Einkapselungsschicht (21) aufgebracht wird, so dass die Durchgangsöffnung (24.1) verschlossen wird; und
- einem zweiten Teilschritt des Eliminierens der Opferschicht (26.4), die zwischen den Hochindexabschnitten (36) der strukturierten Schicht (35) gelegen ist, wobei die Hochindexschicht (33B) des oberen halbreflektierenden Spiegels (32B) eine Durchgangsöffnung (24.3) umfasst.

## Claims

1. Device (1) for detecting electromagnetic radiation, including:
- a substrate (2);
- at least one thermal detector (10), placed on the substrate;
- an encapsulating structure (20) arranged so as to define with the substrate a cavity (3) housing said thermal detector, including at least one thin encapsulating layer (21) extending above the thermal detector;
**characterized in that** it furthermore includes:
- at least one Fabry-Perot interference filter (31) placed level with the encapsulating structure and away from the thermal detector, said filter being formed by first and second semi-reflective mirrors (32A, 32B) that are separated from each other by a layer (35) called the structured layer;
∘ each semi-reflective mirror (32A, 32B) including what is called a high-refractive-index layer (33A, 33B) made of at least one dielectric or semiconductor material, said layer having a thickness equal to a multiple of the ratio of a reference wavelength comprised in a detection spectral domain of the thermal detector (10) over four times its refractive index;
∘ the structured layer (35) including an alternation, in a plane parallel to the plane of the substrate, of what are called high-refractive-index sections (36) made from at least one dielectric or semiconductor material, and what are called low-refractive-index sections (37) made from a medium the refractive index of which is lower than that of the material of the high-index sections;
∘ the high-index layer (33A) of one of said semi-reflective mirrors (32A) being at least partially formed from said thin encapsulating layer (21).

2. Detecting device (1) according to Claim 1, wherein each semi-reflective mirror (32A, 32B) includes a single high-index layer (33A, 33B), and at least one of said semi-reflective mirrors includes what is called a low-index layer (34A, 34B) made from a medium the refractive index of which is lower than that of the material of the high-index layer (33A, 33B), said low-index layer (34A, 34B) being located between the high-index layer (33A, 33B) and the structured layer (35).

3. Detecting device (1) according to Claim 2, wherein the difference between the refractive index of the material of the high-index layer (33A, 33B) and that of the medium of the low-index layer (34A, 34B) is larger than or equal to 1.5.

4. Detecting device (1) according to Claim 2 or 3, wherein the medium of the low-index layer (34A, 34B) and of the low-index sections (37) is vacuum or a gas.

5. Detecting device (1) according to any one of Claims 1 to 4, wherein the high-index layer (33A, 33B) of at least one of said semi-reflective mirrors is formed from a stack of at least two sublayers (33A.1, 33A.2; 33A.1, 33A.2) that make contact with one another and that are made from different materials.

6. Detecting device (1) according to any one of Claims 1 to 5, wherein the structured layer (35) has a proportion by volume of high-index sections (36) higher than or equal to 30%.

7. Detecting device (1) according to any one of Claims 1 to 6, wherein the structured layer (35) includes a continuous layer (41) on which the high-index sections (36) rest.

8. Detecting device (1) according to any one of Claims 1 to 7, wherein the high-index layer (33B) of what is called an upper semi-reflective mirror (32B) includes what is called an upper wall (39) located facing the structured layer (35), and what are called lateral walls (40) located on either side of the upper wall (39), the structured layer (35) being maintained above the high-index layer (33A) of what is called a lower semi-reflective mirror (32A) by the lateral walls (40).

9. Detecting device (1) according to any one of Claims 1 to 8, wherein the thin encapsulating layer (21) extends continuously around the thermal detector (10) so as to form an upper wall (22) located above the thermal detector (10) and a lateral wall (23) resting on the substrate (2).

10. Detecting device (1) according to any one of Claims 1 to 9, including:
- a plurality of thermal detectors (10) placed on the substrate (2), above which detectors said thin encapsulating layer (21) extends;
- a plurality of Fabry-Perot interference filters (31) each placed level with the encapsulating structure (30);
- the thin encapsulating layer (21) being common to a plurality of high-index layers (33A) of one of said semi-reflective mirrors (32A) of the various interference filters (31).

11. Detecting device (1) according to Claim 10, wherein the semi-reflective mirrors (32A, 32B) and the structured layers (35) of the interference filters (31) are respectively coplanar from one interference filter to the next.

12. Process for producing a detecting device (1) according to any one of Claims 1 to 11, including at least the following steps:
a. producing at least one thermal detector (10);
b. producing an encapsulating structure (20) arranged so as to define with the substrate (2) a cavity (3) housing said thermal detector, including at least one thin encapsulating layer (21) extending above the thermal detector and resting on a sacrificial layer (26.2) covering said thermal detector;
c. producing at least one Fabry-Perot interference filter (31), a sacrificial layer (26.4) being located between the high-index sections (36) of the structured layer (35), and optionally between a high-index layer (33A, 33B) and the structured layer (35);
d. removing said sacrificial layers (26.2, 26.4).

13. Producing process according to Claim 12, wherein the sacrificial layers (26.2, 26.4) are removed in the same step, subsequently to the step of producing the interference filter (31), the sacrificial layers (26.2, 26.4) being made from the same material, the high-index layers (33A, 33B) of the two semi-reflective mirrors (32A, 32B) each including a through-orifice (24.1, 24.3), and the low-index sections (37) of the structured layer (35) being through-sections.

14. Producing process according to Claim 12, wherein the sacrificial layers are removed in two substeps:
- a first sub-step of removing the sacrificial layer (26.2) on which the thin encapsulating layer (21) rests, carried out before the step of producing the interference filter (31), the thin encapsulating layer (21) including a through-orifice (24.1), and a sealing layer (33A.2) then being deposited on the thin encapsulating layer (21) so as to block the through-orifice (24.1); and
- a second sub-step of removing the sacrificial layer (26.4) located between the high-index sections (36) of the structured layer (35), the high-index layer (33B) of the upper semi-reflective mirror (32B) including a through-orifice (24.3).
